(19) **Europäisches Patentamt**

**European Patent Office**

**Office européen des brevets**

(11) **EP 1 699 270 A2**

(12) **EUROPEAN PATENT APPLICATION**
published in accordance with Art. 158(3) EPC

(43) Date of publication:
06.09.2006 Bulletin 2006/36

(51) Int Cl.:
*H05B 33/26* (2006.01)   *B32B 7/02* (2006.01)
*B32B 9/00* (2006.01)   *H01B 5/14* (2006.01)
*H01B 13/00* (2006.01)   *H05B 33/10* (2006.01)
*H05B 33/14* (2006.01)   *H05B 33/28* (2006.01)

(21) Application number: 04820680.9

(22) Date of filing: 08.12.2004

(86) International application number:
**PCT/JP2004/018263**

(87) International publication number:
**WO 2005/062678 (07.07.2005 Gazette 2005/27)**

(84) Designated Contracting States:
**AT BE BG CH CY CZ DE DK EE ES FI FR GB GR HU IE IS IT LI LT LU MC NL PL PT RO SE SI SK TR**

(30) Priority: **19.12.2003 JP 2003422191**
**23.03.2004 JP 2004084016**
**14.04.2004 JP 2004118484**

(71) Applicant: **IDEMITSU KOSAN CO., LTD.**
**Tokyo 100-8321 (JP)**

(72) Inventors:
• **TOMAI, Shigekazu**
**Chiba 2990293 (JP)**

• **INOUE, Kazuyoshi**
**Chiba 2990293 (JP)**
• **SHIBUYA, Tadao**
**Chiba 2990293 (JP)**
• **SAKAI, Toshio**
**Chiba 2990293 (JP)**
• **MATSUBARA, Masato**
**Chiba 2990293 (JP)**

(74) Representative: **Gille Hrabal Struck Neidlein Prop Roos**
**Brucknerstrasse 20**
**40593 Düsseldorf (DE)**

(54) **ORGANIC ELECTROLUMINESCENCE DEVICE, CONDUCTIVE LAMINATE AND DISPLAY**

(57) An organic electroluminescent device including a cathode 50, an anode 20, and an emitting layer interposed between the cathode 50 and the anode 20, at least a part of the anode 20 in contact with the emitting layer 40 containing at least one element selected from lanthanum, cerium, neodymium, samarium, and europium, and at least one element selected from chromium, tungsten, tantalum, niobium, silver, palladium, copper, nickel, cobalt, molybdenum, platinum, and silicon. Since holes are efficiently injected into the emitting layer from the anode, the drive voltage of the organic EL device can be decreased, whereby the lifetime of the organic EL device can be increased.

FIG. 1

EMISSION    REFLECTED LIGHT

EP 1 699 270 A2

**Description**

TECHNICAL FIELD

The invention relates to an organic electroluminescent (EL) device, a conductive multilayer body, a method for producing the conductive multilayer body, an electrode substrate for an organic electroluminescent device, and a display.

BACKGROUND ART

An organic EL device includes an anode, a cathode, and an emitting layer placed between the anode and the cathode. The emitting layer includes a luminescent medium layer which emits light upon recombination of holes supplied from the anode and electrons supplied from the cathode. A hole injecting layer and a hole transporting layer are generally provided between the anode and the luminescent medium layer in order to promote injection of holes supplied from the anode. An electron injecting layer and an electron transporting layer are generally provided between the cathode and the luminescent medium layer in order to promote injection of electrons supplied from the cathode.

Since the anode and the cathode play important roles for efficiently injecting electric charges into the emitting layer, the materials for the anode and the cathode have been extensively researched.

The work function of indium tin oxide (ITO) generally used as the hole injecting electrode (anode) is 4.6 to 5.0 eV. On the other hand, the ionization potential of most hole transporting materials represented by triphenyldiamine (TPD) is as large as 5.6 eV. Therefore, an energy barrier of 0.4 to 1.0 eV exists when holes are injected into TPD from ITO. It is then effective to increase the work function of the surface of the anode in order to promote injection of holes into the hole injecting layer from the anode.

A method of increasing the oxygen content of the surface of ITO has been proposed as a means for increasing the work function of ITO. For example, JP-A-8-167479 discloses a method of depositing ITO at room temperature and heating the deposited film in an oxidizing atmosphere or applying oxygen plasma to the deposited film, whereby the work function of 4.6 to 5.0 eV is increased to 5.1 to 6.0 eV. JP-A-2000-68073 discloses a transparent electrode of which the work function is increased to 5.0 to 6.0 eV by increasing the oxygen concentration of sputtering gas on the surface of ITO.

However, these methods have a problem in which the work function decreases with time.

In order to prevent a decrease in the work function in air, JP-A-2001-284060 discloses a method of injecting oxygen ions into deposited ITO. In more detail, the work function of ITO can be increased to 5.2 to 6.0 eV by injecting oxygen ions into ITO at an accelerating voltage of 5 kV for 15 minutes using oxygen plasma generated by a high-frequency discharge. According to this method, a large work function of 6.0 eV can be maintained even after the deposited film is allowed to stand in air for 60 minutes after the oxygen ion injection. However, this method requires a device which generates high-density plasma and uniformly applies ions to the substrate using a control electrode. Moreover, since it is difficult to uniformly apply oxygen ions over a large area, uniform quality cannot be secured.

JP-A-2001-043980 suggests that the anode need not necessarily be transparent by using a transparent electrode for the cathode. This increases the range of selection of the materials. JP-A-2001-043980 discloses conductive oxides such as In-Zn-O, In-Sn-O, ZnO-Al, and Zn-Sn-O, metals such as Au, Pt, Ni, and Pd, and black semiconductor oxides such as $Cr_2O_3$, $Pr_2O_5$, NiO, $Mn_2O_5$, and $MnO_2$ as preferable materials. In particular, JP-A-2001-043980 discloses that Cr is an excellent anode material since the use of Cr allows holes to be sufficiently supplied even if the work function is relatively small (4.5 eV).

However, it is preferable in principle that the work function be large in order to further increase the hole injecting properties. Specifically, if holes can be smoothly injected into the emitting layer from the anode, the drive voltage of the organic EL device can be decreased and the lifetime of the organic EL device can be therefore increased.

When outcoupling light generated by the emitting layer through the side of the cathode, the cathode is required to exhibit excellent transparency in addition to having a low resistivity in order to efficiently outcouple light to the outside. Therefore, silver (Ag) which exhibits excellent optical properties (e.g. optical transparency) in the visible region has been widely used as the material for the cathode. For example, JP-A-2001-043980 discloses an organic EL device using a cathode made of an Mg-Ag alloy.

However, since Ag diffuses into the emitting layer or the like forming the EL device due to high diffusion (migration) properties, deterioration of the EL device or a short circuit occurs.

DISCLOSURE OF THE INVENTION

An object of the invention is to provide an organic EL device and a display having an anode exhibiting high hole injecting properties and/or a stable cathode which does not undergo diffusion or the like.

As described above, JP-A-2001-043980 discloses that a group V or IV metal having a small work function (e.g.

Cr, Mo, W, Ta, or Nb) can be used as the anode instead of a metal having a large work function (e.g. Au, Pt, Ni, or Pd). The inventors of the invention found that the work function and the hole injecting efficiency can be increased while utilizing adhesion and microprocessability of the group V or IV metal by adding at least one element selected from lanthanum, cerium, neodymium, samarium, and europium to the group V or IV metal having a small work function (first invention).

The inventors of the invention also found that a conductive multilayer body having a large work function and exhibiting excellent hole injecting efficiency can be obtained by sputtering using an oxide sintered product containing Ce as a target in a sputtering atmosphere under specific conditions, that is, at a partial pressure of oxygen of 0.1 Pa or less (second invention).

The inventors of the invention also found that diffusion of metal atoms in the device can be prevented by using two types of metals in combination for the cathode layer, the standard oxidation-reduction potentials of these metals satisfying a specific relationship (third invention).

According to the invention, the following organic EL device, conductive multilayer body, method for producing the conductive multilayer body, electrode substrate for an organic electroluminescent device, and display can be provided.

1. An organic electroluminescent device comprising a cathode, an anode, and an emitting layer interposed between the cathode and the anode, at least a part of the anode in contact with the emitting layer containing at least one element selected from lanthanum, cerium, neodymium, samarium, and europium, and at least one element selected from chromium, tungsten, tantalum, niobium, silver, palladium, copper, nickel, cobalt, molybdenum, platinum, and silicon.

2. The organic electroluminescent device according to 1, wherein the total concentration of the at least one element selected from lanthanum, cerium, neodymium, samarium, and europium is 0.1 to 50 wt%.

3. The organic electroluminescent device according to 1 or 2, wherein the part of the anode in contact with the emitting layer contains cerium.

4. The organic electroluminescent device according to any one of 1 to 3, wherein the part of the anode in contact with the emitting layer has a work function of 5.0 eV or more.

5. A conductive multilayer body comprising an insulative transparent substrate and a transparent conductive film formed on the transparent substrate, the transparent conductive film containing an oxide containing at least cerium (Ce), wherein, in a graph showing binding energy of an electron present in a cerium 3d orbit on the surface of the transparent conductive film measured by X-ray photoelectron spectroscopy, when SA represents the total peak area of the binding energy between 877 eV and 922 eV, and SB represents the total peak area of the binding energy between 914 eV and 920 eV, SB/SA which represents an area ratio of SB to SA satisfies the following expression (1).

$$SB/SA < 0.13 \qquad (1)$$

6. The conductive multilayer body according to 5, wherein the transparent conductive film contains at least one metal element selected from indium (In), tin (Sn), Zinc (Zn), zirconium (Zr), and gallium (Ga), cerium (Ce), and oxygen (O).

7. A method for producing the conductive multilayer body of 5 or 6, comprising forming the transparent conductive film by sputtering at a partial pressure of oxygen of 0.1 Pa or less in a sputtering atmosphere.

8. An electrode substrate for an organic electroluminescent device comprising the conductive multilayer body of any one of 5 to 7, and a metal conductor formed on the conductive multilayer body, the transparent conductive film driving an organic electroluminescent layer.

9. An organic electroluminescent device comprising the electrode substrate of 8, and an organic electroluminescent layer formed on the electrode substrate.

10. An organic electroluminescent device comprising the conductive multilayer body of any one of 5 to 7, and an organic electroluminescent layer formed on the conductive multilayer body.

11. An electroluminescent device comprising an anode layer, an organic emitting layer, and a cathode layer stacked in this order, the cathode layer containing at least a first metal and a second metal, the standard oxidation-reduction potential (E(A)) of the first metal at 25°C being -1.7 (V) or more, and the standard oxidation-reduction potential (E (B)) of the second metal at 25°C satisfying the following expression (2).

$$E(A) - 1.1 \leq E(B) \qquad (2)$$

12. An electroluminescent device comprising an anode layer, an organic emitting layer, a cathode layer, and a transparent conductive layer stacked in this order, the cathode layer containing at least a first metal and a second metal, the standard oxidation-reduction potential (E(A)) of the first metal at 25°C being -1.7 (V) or more, and the standard oxidation-reduction potential (E (B)) of the second metal at 25°C satisfying the following expression (2).

$$E(A) - 1.1 \leq E(B) \qquad (2)$$

13. The organic electroluminescent device according to 11 or 12, wherein the main component of the cathode layer is the first metal.

14. The organic electroluminescent device according to any one of 11 to 13, wherein the first metal is a metal selected from Al, Cr, Ta, Zn, Fe, Ti, In, Co, Ni, Ge, Cu, Re, Ru, Ag, Pd, Pt, and Au.

15. The organic electroluminescent device according to any one of 11 to 14, wherein the second metal is a metal selected from Bi, Te, Sn, V, Mo, Nd, Nb, and Zr.

16. The organic electroluminescent device according to any one of 11 to 15, wherein the cathode layer contains 0.1 wt% to 5.0 wt% of an alkali metal or an alkaline earth metal.

17. The organic electroluminescent device according to any one of 11 to 16, wherein the cathode layer has an optical transparency at a wavelength of 380 nm to 780 nm of 10% or more.

18. The organic electroluminescent device according to any one of 11 to 17, wherein the first metal is Ag.

19. A display comprising the organic electroluminescent device according to any one of 1 to 4, 9, 10, and 14 to 21.

According to the invention, since holes are efficiently injected into the emitting layer from the anode, the drive voltage of the organic EL device can be decreased, whereby the lifetime of the organic EL device can be increased. Since the conductive multilayer body and the electrode substrate according to the invention have a large work function, a high-luminance organic EL device which shows a small increase in voltage during constant current drive and exhibits a long lifetime can be realized by using the conductive multilayer body or the electrode substrate as an electrode of the organic EL device. According to the method for producing the conductive multilayer body according to the invention, the above-described conductive multilayer body can be efficiently obtained.

In the organic EL device according to the invention, since metals used for the cathode layer can be prevented from diffusing in the device, deterioration of the device or occurrence of a short circuit due to metal diffusion can be prevented, whereby the lifetime of the EL device can be increased.

BRIEF DESCRIPTION OF THE DRAWINGS

FIG. 1 is a view showing an organic EL device according to a first embodiment.

FIG. 2 is a view showing an equivalent circuit of one pixel according to a second embodiment.

FIG. 3 is a view showing an active matrix type display according to the second embodiment.

FIG. 4 is a view showing the cross-sectional structure of one pixel according to the second embodiment.

FIG. 5 is a view showing an organic EL device according to a third embodiment.

FIG. 6 is a graph showing an example of a binding energy spectrum of a cerium 3d orbit which falls under the invention.

FIG. 7 is a graph showing an example of a binding energy spectrum of a cerium 3d orbit which does not fall under the invention.

FIG. 8 is a view showing an organic EL device according to a fourth embodiment.

FIG. 9 is an explanatory diagram showing steps of producing a transparent conductive substrate.

FIG. 10 is a view showing the chemical formulas of deposition materials of examples.

BEST MODE FOR CARRYING OUT THE INVENTION

Embodiments of the first to third inventions are described below in detail with reference to the drawings. The invention is not limited to these embodiments.

(First Invention)

First Embodiment

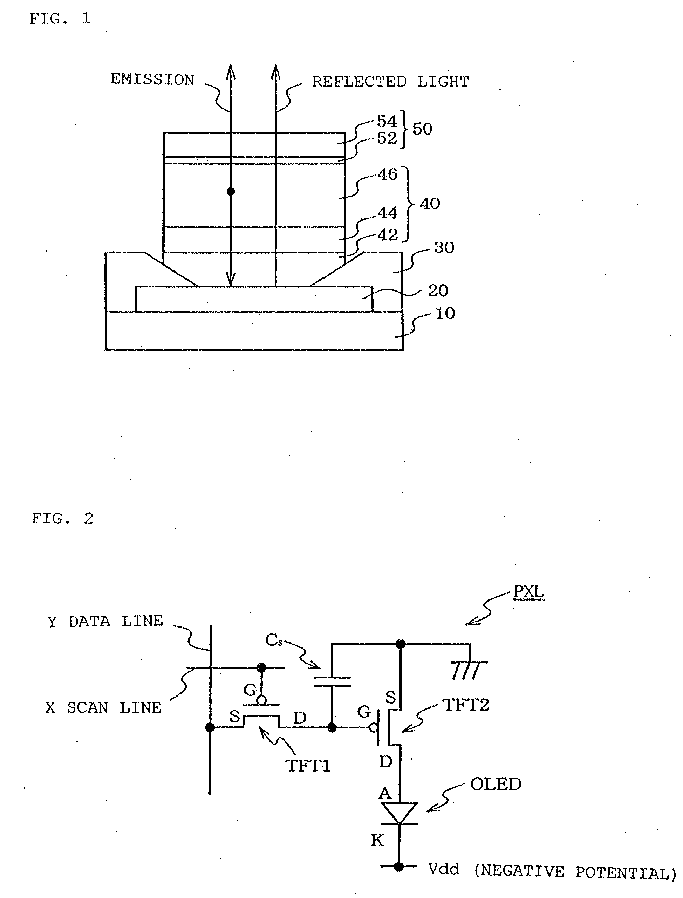

FIG. 1 is a view showing one embodiment of an organic EL device according to the invention. An anode 20, an insulating layer 30, an emitting layer 40, and a cathode 50 are formed on a substrate 10. The emitting layer 40 includes a hole injecting layer 42, a hole transporting layer 44, and a luminescent medium layer 46. The cathode 20 includes a metal layer 22 and a transparent conductive layer 24. The insulating layer 30 is not indispensable, but is preferably provided in order to prevent a short circuit between the anode 20 and the cathode 50.

In the luminescent medium layer 46, holes supplied from the anode 20 and electrons supplied from the cathode recombine to emit light. The light is outcoupled upward through the cathode 50.

According to the first embodiment, at least a part of the anode 40 in contact with the hole injecting layer 42 contains at least one element selected from lanthanum, cerium, neodymium, samarium, and europium, and at least one element selected from chromium, tungsten, tantalum, niobium, silver, palladium, copper, nickel, cobalt, molybdenum, platinum, and silicon. The total concentration of the at least one element selected from lanthanum, cerium, neodymium, samarium, and europium is preferably 0. 1 to 50 wt%, and still more preferably 1 to 30 wt% of the total concentration of the elements contained in that part of the anode.

The work function of the anode 20 is increased by adding at least one element selected from lanthanum, cerium, neodymium, samarium, and europium to an element having a relatively low work function. Therefore, the hole injection efficiency from the anode 20 to the emitting layer 40 is increased. As a result, the drive voltage of the organic EL device is decreased, whereby the lifetime of the organic EL device can be increased. The work function is preferably 5.0 eV or more.

In the first embodiment, a part of the light generated in the luminescent medium layer 46 of the emitting layer 40 is directly emitted to the outside through the cathode 50, and another part of the light is emitted toward the anode 20. Since the anode 20 contains at least one element selected from lanthanum, cerium, neodymium, samarium, and europium, and at least one element selected from chromium, tungsten, tantalum, niobium, silver, palladium, copper, nickel, cobalt, molybdenum, platinum, and silicon, light generated in the luminescent medium layer 46 is partially reflected at the interface between the emitting layer 40 and the anode 20 and emitted through the cathode 50. Therefore, light generated in the emitting layer 40 can be efficiently outcoupled from the upper surface.

The organic EL device according to the first embodiment is of the top emission type. The anode 20 may also be used for a bottom emission type organic EL device.

In the first embodiment, the emitting layer includes the hole injecting layer and the hole transporting layer. Note that these layers may be omitted. The emitting layer may also include an electron injecting layer, a hole transporting layer, an adhesion improving layer, a barrier layer, and the like.

Second Embodiment

FIGS. 2, 3, and 4 are views showing one embodiment of a display using the organic EL device according to the invention.

FIG. 2 is a view showing an equivalent circuit of one pixel of an active matrix type display.

In the active matrix type display, a number of pixels are arranged in a matrix, and an image is displayed by controlling the light intensity in pixel units corresponding to luminance information provided. In the active matrix type display, current flowing through an organic EL device provided in each pixel is controlled by an active device (generally a thin film transistor (TFT) which is one type of insulated gate type field effect transistor) provided in each pixel.

A pixel PXL includes an organic EL device OLED, a thin film transistor TFT1 as a first active device, a thin film transistor TFT2 as a second active device, and a storage capacitor Cs. Since the organic EL device generally has rectification properties, it may be called an organic light emitting diode (OLED). In FIG. 2, the organic EL device is indicated by a diode symbol. In the example shown in FIG. 2, a source S of the thin film transistor TFT2 is set at a reference potential (ground potential), a cathode K of the organic EL device OLED is connected with a power supply potential (Vdd), and the anode 20 is connected with a drain D of the thin film transistor TFT2. A gate G of the thin film transistor TFT1 is connected with a scan line X, a source S thereof is connected with a data line Y, and a drain D thereof is connected with the storage capacitor Cs and a gate G of the thin film transistor TFT2.

The pixel PXL is operated as described below. First, when the scan line X is selected and a data potential Vdata indicating the luminance information is applied to the data line Y, the thin film transistor TFT1 is turned ON so that the storage capacitor Cs is charged or discharged, whereby the gate potential of the thin film transistor TFT2 coincides with the data potential Vdata. When the scan line X is unselected, the thin film transistor TFT1 is turned OFF so that the thin film transistor TFT2 is electrically disconnected from the data line Y. The gate potential of the thin film transistor TFT2 is maintained by the storage capacitor Cs. A current flowing through the organic EL device OLED via the thin film transistor TFT2 is set at a value corresponding to a voltage Vgs between the gate and the source of the thin film transistor TFT2, and the organic EL device OLED continuously emits light at a luminance corresponding to the amount of current supplied from the thin film transistor TFT2.

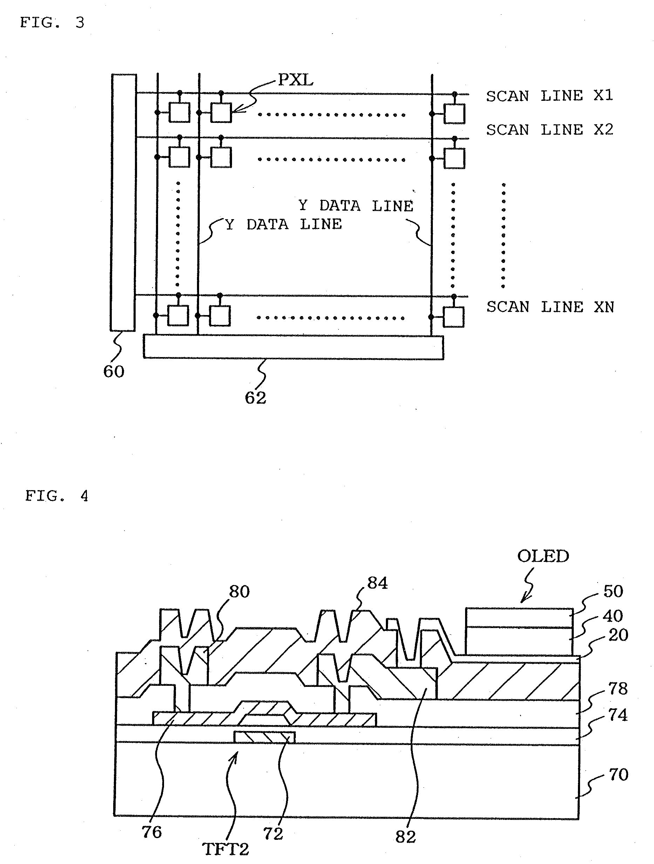

As described above, in the circuit configuration of the pixel PXL shown in FIG. 2, after the luminance information indicated by the data potential Vdata has been written, the organic EL device OLED continuously emits light at a constant luminance in one frame until the luminance information is rewritten. An active matrix type display can be formed by arranging a number of pixels PXL in a matrix as shown in FIG. 3.

In the display shown in FIG. 3, the scan lines X1 to XN for selecting the pixels PXL and the data line Y for supplying the luminance information (data potential Vdata) for driving the pixels PXL are arranged in a matrix. The scan lines X1 to XN are connected with a scan line driver circuit 60, and the data lines Y are connected with a data line driver circuit 62. A desired image can be displayed by causing the scan line driver circuit 60 to sequentially select the scan lines X1 to XN and causing the data line driver circuit 62 to repeatedly write the data potential Vdata through the data lines Y. In a simple matrix type display, the emitting device included in each pixel PXL momentarily emits light only when the pixel is selected. In the active matrix type display shown in FIG. 3, the organic EL device of each pixel PXL continuously emits light after the data potential Vdata has been written. Therefore, the active matrix type display is advantageous for a large and high definition display in comparison with the simple matrix type display in that the peak luminance (peak current) of the organic EL device can be decreased.

FIG. 4 schematically shows a cross-sectional structure of the pixel PXL shown in FIG. 2. FIG. 2 shows only the organic EL device OLED and the thin film transistor TFT2 for convenience of illustration. The organic EL device OLED is formed by stacking the anode 20, the emitting layer 40, and the cathode 50. The anode 20 is separated between pixel units and basically reflects light. The cathode 50 is commonly connected to each pixel and basically transmits light.

The thin film transistor TFT2 includes a gate electrode 72 formed on a substrate 70 made of glass or the like, a gate insulating film 74 stacked on the upper surface of the gate electrode 72, and a semiconductor thin film 76 stacked above the gate electrode 72 with the gate insulating film 74 therebetween. The semiconductor thin film 76 is a polycrystalline silicon thin film, for example. The thin film transistor TFT2 has a source S, a channel Ch, and a drain D forming a path for current supplied to the organic EL device OLED. The channel Ch is positioned directly on the gate electrode 72. The thin film transistor TFT2 having a bottom gate structure is covered with an inter-insulator 78, and a source electrode 80 and a drain electrode 82 are formed on the inter-insulator 78. The organic EL device OLED is formed above the source electrode 80 and the drain electrode 82 with an inter-insulator 84 therebetween.

The second embodiment illustrates the active matrix type display. The display according to the invention may be a simple matrix type display. The display according to the invention may also have other known configurations.

(Second Invention)

Third Embodiment

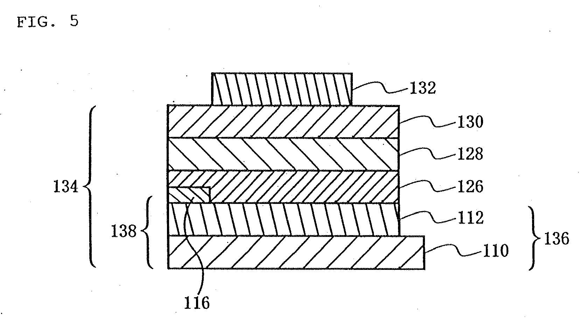

FIG. 5 is a view showing one embodiment of an organic EL device according to the invention.

An organic EL device 134 corresponds to an example of the organic EL device defined in the claims. The organic EL device 134 includes a transparent conductive substrate 138 including a glass substrate 110 and a transparent conductive film 112, a hole transporting layer 126, an organic emitting layer 128, an electron injecting layer 130, and a cathode layer 132.

A feature of the third embodiment is to produce the transparent conductive substrate 138 including the transparent conductive film 112 having a large work function. Another feature of the third embodiment is to produce the organic EL device 134 which shows a small increase in voltage during constant current drive and exhibits long lifetime and high luminance using the transparent conductive substrate 138 as an electrode.

Each constituent member and the production method are described below.

A. Conductive multilayer body

A conductive multilayer body according to the invention includes an insulative transparent substrate and a transparent conductive film formed on the transparent substrate, the transparent conductive film containing an oxide containing at least cerium (Ce), wherein, in a graph (hereinafter may be called "$Ce_{3d}$ peak") showing binding energy of an electron present in a cerium 3d orbit (hereinafter may be called "3d electron") on the surface of the transparent conductive film measured by X-ray photoelectron spectroscopy (hereinafter may be called "XPS method"), when SA represents the total peak area of the binding energy between 877 eV and 922 eV and SB represents the total peak area of the binding energy between 914 eV and 920 eV, SB/SA which represents an area ratio of SB to SA satisfies the

following expression (1).
$$SB/SA < 0.13 \qquad (1)$$

The SA target range "877 eV to 922 eV" indicates the binding energy of the 3d electrons of $Ce^{3+}$ and $Ce^{4+}$. The SB target range "914 eV to 920 eV" indicates the binding energy of the 3d electrons of $Ce^{4+}$. Therefore, the concentration of $Ce^{4+}$ in Ce of the transparent conductive film can be relatively specified by the ratio "SB/SA" by calculating the ratio of the binding energy peak areas of SA and SB. Specifically, the concentration of $Ce^{4+}$ in Ce of the transparent conductive film can be set at a small value.

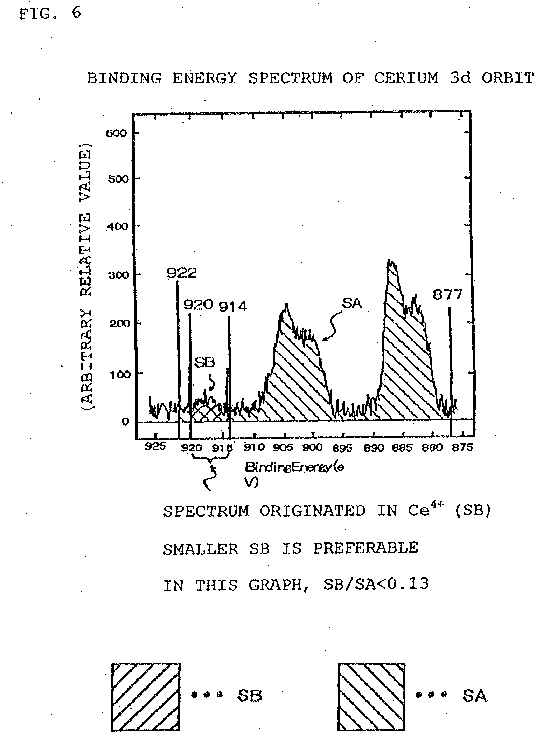

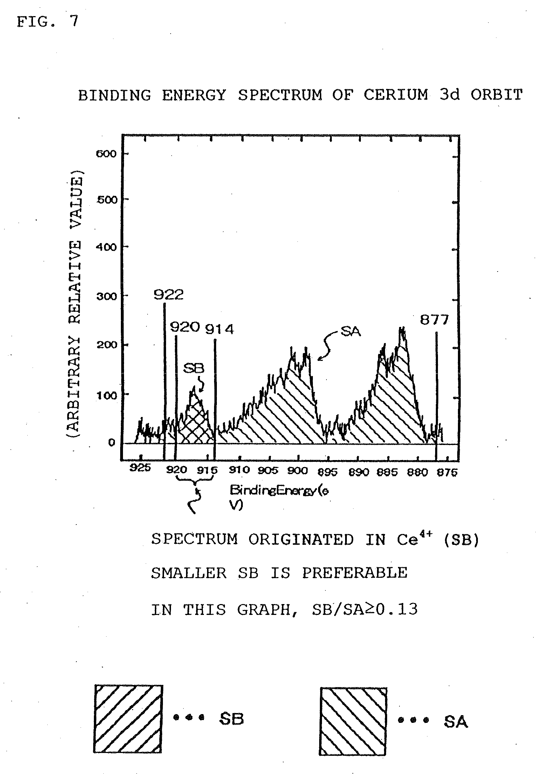

FIGS. 6 and 7 show examples of the XPS binding energy spectra of the cerium 3d orbit on the surface of the transparent conductive film. The horizontal axis in FIGS. 6 and 7 indicates the amount (eV) of binding energy of the Ce 3d electron, and the vertical axis indicates an arbitrary relative value. The measurement conditions for the XPS Ce 3d electron binding energy spectrum are described in detail in the examples.

The Ce 3d electron binding energy spectra in FIGS. 6 and 7 show the total peak area SA between 877 eV and 922 eV and the total peak area SB between 914 eV and 920 eV. The total peak area used herein refers to the area enclosed by the X axis and the Ce 3d electron binding energy spectrum in each range ("877 eV to 922 eV" or "914 eV to 920 eV") shown in FIGS. 6 and 7. The total peak area is equal to the integrated value from 877 eV to 922 eV (or 914 eV to 920 eV) for the Ce 3d electron binding energy spectrum shown in FIG. 6.

The "Ce 3d electron binding energy spectrum" shown in FIG. 6 corresponds to an example of the "graph showing binding energy of an electron present in a cerium 3d orbit on the surface of the transparent conductive film measured by X-ray photoelectron spectroscopy" defined in the claims.

FIG. 6 shows an example of the binding energy spectrum of the cerium 3d orbit when the ratio "SB/SA" (area ratio of SB to SA) is less than 0.13. FIG. 7 shows an example of the binding energy spectrum of the cerium 3d orbit when the ratio "SB/SA" (area ratio of SB to SA) is greater than 0.13.
The transparent conductive film according to the invention is characterized in that the ratio "SB/SA" (area ratio of SB to SA) is less than 0.13, as shown in FIG. 6. A transparent conductive film satisfying this condition has a large work function.

An organic EL device (hereinafter may be called "organic electroluminescent device") which shows a small increase in voltage during constant current drive and exhibits a long lifetime and high luminance can be provided by using the conductive multilayer body including the transparent conductive film defined by the expression (1) as the anode thereof. It suffices that the ratio "SB/SA" of the conductive multilayer body be less than 0.13. The ratio "SB/SA" is preferably less than 0.08, and still more preferably less than 0.03.

If the measured peaks satisfy the expression (1) in the graph showing the binding energy of an electron present in the cerium 3d orbit on the surface of the transparent conductive film measured using an X-ray photoelectron spectroscope (hereinafter may be called "XPS"), the surface of the transparent conductive film has a work function of 5.6 eV or more. The work function of the surface of the transparent conductive film is measured by ultraviolet photoelectron spectroscopy. The measurement conditions for the work function are described in detail in the examples.

In the conductive multilayer body according to the invention, the work function measured by ultraviolet photoelectron spectroscopy is set at 5.6 eV or more for the following reason. Specifically, when a conductive multilayer body includes a transparent conductive film having a work function of less than 5.6 eV, an organic EL device produced using such a conductive multilayer body may exhibit decreased luminance and show decreased lifetime due to an increase in drive voltage of the organic EL device.

In the conductive multilayer body according to the invention, the transparent conductive film contains at least one metal element selected from indium (In), tin (Sn), zinc (Zn), zirconium (Zr) and gallium (Ga), and cerium (Ce) and oxygen (O). The term "contains" typically means that the transparent conductive film contains the above-mentioned metal atom as the constituent element, for example.

B. Method for producing conductive multilayer body

A method for producing the conductive multilayer body according to the invention includes forming the transparent conductive film by sputtering at a partial pressure of oxygen of 0.1 Pa or less in a sputtering atmosphere.

The transparent conductive film of the conductive multilayer body according to the invention is formed on the transparent substrate by sputtering using a sputtering target. The deposition by sputtering may be carried out using various sputtering devices. In particular, a magnetron sputtering device is suitably used.

The conditions for depositing the transparent conductive film on the transparent substrate using the magnetron sputtering device are as follows. The plasma output varies depending on the surface area of the target used and the thickness of the transparent conductive film to be stacked. In the invention, it is preferable to set the plasma output at 0.3 to 4 W per unit surface area (1 cm$^2$) of the target. A transparent conductive film having a desired thickness can be obtained by setting the deposition time at 5 to 120 minutes. Specifically, a thickness suitable for use in the organic EL device can be obtained by using such a deposition time.

As the atmosphere gas during sputtering, an inert gas such as argon, nitrogen or helium, or a mixed gas of such an inert gas and oxygen is preferably used. The optimum sputtering pressure varies depending on the type of sputtering device, the distance between the transparent substrate and the target, the temperature of the transparent substrate, and the like. The partial pressure of oxygen is preferably 0.1 Pa or less. The partial pressure of oxygen is still more preferably 0.02 Pa or less.

The reason that the partial pressure of oxygen is set at 0.1 Pa or less is as follows. Specifically, when the partial pressure of oxygen is greater than 0.1 Pa, the amount of Ce$^{3+}$ included in the transparent conductive film decreases in comparison with Ce$^{4+}$, whereby the ratio "SB/SA" may exceed 0. 13.
Note that SA indicates the total peak area of the binding energy between 877 eV and 922 eV in the Ce$_{3d}$ peak on the surface of the transparent conductive film measured by the XPS, and SB indicates the total peak area of the binding energy between 914 eV to 920 eV, as described above.

The transparent substrate of the conductive multilayer body is not particularly limited. A plate-shaped member or a film-shaped member made of known transparent glass, quartz, transparent plastic, transparent ceramics, or the like may be used.
As specific examples of the transparent glass, soda-lime glass, lead silicate glass, borosilicate glass, silicate glass, high silicate glass, non-alkali glass, phosphate glass, alkali silicate glass, quartz glass, aluminoborosilicate glass, barium borosilicate glass, sodium borosilicate glass, and the like can be given.

As specific examples of the transparent plastic, polycarbonate, polyallylate, polyester, polystyrene, polyethersulfone resin, amorphous polyolefin, acrylic resin, polyimide, polyphosphazene, polyether ether ketone, polyamide, polyacetal resin, and the like can be given.

As specific examples of the transparent ceramics, sapphire, PLZT, CaF$_2$, MgF$_2$, ZnS, and the like can be given. The material, the thickness, and the like of the transparent substrate are arbitrarily selected depending on the application of the conductive transparent substrate (conductive multilayer body), the transparency required for the conductive transparent substrate, and the like.
The transparent conductive film is deposited on the transparent substrate by sputtering using an oxide target containing an oxide containing at least cerium (Ce). It is preferable that the oxide target be an oxide sintered product, for example.

In the composition forming the deposited transparent conductive film, cerium must be mixed with a known transparent conductive metal oxide (In$_2$O$_3$, SnO$_2$, ZnO, CdO, Cd-In-O oxide, Zn-Al-O oxide, In-Sn-O oxide, In-Zn-O oxide, Zn-Sn-O oxide, Cd-Sn-O oxide, or the like).

In the case of using the conductive multilayer body thus obtained as the electrode for the organic EL device, when the conductivity of the transparent conductive film of the conductive multilayer body is not sufficiently high, the ohmic loss during driving may be decreased and the conductivity may be improved by stacking a metal conductor on the transparent conductive film. In particular, since a passive matrix type organic EL device uses a method of causing the display electrode section to emit light by sequential scan, the effect of stacking a metal conductor on the transparent conductive film is greater in comparison with an active matrix type organic EL device.

C. Electrode substrate for organic electroluminescent (EL) device
An electrode substrate for an organic electroluminescent device according to the invention includes the above-described conductive multilayer body and a metal conductor formed on the conductive multilayer body, the transparent conductive film driving an organic electroluminescent layer.

The metal used for the metal conductor is stacked on the transparent conductive film in order to improve the conductivity of the transparent conductive film, and is not particularly limited insofar as the metal exhibits conductivity higher than that of the transparent conductive film. There may be a case where the work function of the surface of the transparent conductive film decreases after etching the metal on the transparent conductive film due to a oxidation-reduction reaction at the interface between the transparent conductive film and the metal. Therefore, the work function of the metal used for the metal conductor is preferably about 4.0 eV or more. The work function of the metal used for the metal conductor is still more preferably 4.5 eV or more.

It is preferable that the metal conductor be a thin metal wire in order to efficiently outcouple light from the organic emitting layer. The thin metal wire is described below.
A thin metal wire is generally formed by depositing a metal on the upper surface of the transparent conductive film of the conductive multilayer body by a vacuum process such as sputtering or vacuum deposition, and then forming the deposited metal into a thin wire pattern by etching. In the invention, a thin metal wire may be formed on the upper surface of the transparent conductive film by such a general method.

The etchant for the metal is not particularly limited. It is preferable to select an etchant which rarely damages the transparent conductive film under the deposited metal. As examples of such an etchant, a mixed acid of phosphoric acid, acetic acid, and nitric acid can be given. It is also preferable to add sulfonic acid, polysulfonic acid, or the like to the mixed acid.

The thin metal wire may preferably have a multilayer structure such as a two-layer or three layer structure, or may preferably be made of an alloy of two or more metals. As configuration examples of the multilayer structure, Ti/Al/Ti, Cr/Al/Cr, Mo/Al/Mo, In/Al/In, Zn/Al/Zn, Ti/Ag/Ti, and the like can be given. As examples of the alloy of two or more metals, Al-Si, Al-Cu, Al-Nd, Cu-Zr, Cu-Ni, Cu-Cr, Mo-V, Mo-Nb, Ag-Au-Cu, Ag-Pd-Cu, and the like can be given.

D. Organic EL device

An organic electroluminescent device according to the invention includes the above-described electrode substrate for an organic EL device, and an organic electroluminescent layer formed on the electrode substrate.

Another organic electroluminescent device according to the invention includes the above-described conductive multilayer body, and an organic electroluminescent layer formed on the conductive multilayer body.

The organic EL device according to the invention includes the conductive multilayer body (or electrode substrate for organic EL device) having a large work function, as described above. Therefore, the organic EL device is expected to show a small increase in voltage during constant current drive and exhibit long lifetime and high luminance. The invention is particularly effective for a passive drive type organic EL device for which an instantaneous high luminance operation is required. Note that the invention may also provide an active drive type organic EL device with increased luminance and lifetime.

(Third Invention)

An organic EL device according to the invention includes at least an anode layer, an organic emitting layer, and a cathode layer stacked in this order, the cathode layer containing at least a first metal and a second metal.

The standard oxidation-reduction potential (E (A)) at 25°C of the first metal used for the cathode layer is -1.7 (V) or more.

As preferable examples of the first metal, Al, Cr, Ta, Zn, Fe, Ti, In, Co, Ni, Ge, Cu, Re, Ru, Ag, Pd, Pt, and Au can be given. Of these metals, Ag, Cr, Cu, Pt, or Au is preferable, with Ag being particularly preferable.

The standard oxidation-reduction potential (E (B)) at 25°C of the second metal satisfies the following expression (2) in relation to the first metal.

$$E(A) - 1.1 \leq E(B) \qquad (2)$$

The standard oxidation-reduction potential (E(B)) of the second metal preferably satisfies "E (A) - 0.5 ≤ E (B)", and still more preferably satisfies "E(A) - 0.3 ≤ E(B)".

The second metal is appropriately selected corresponding to the first metal. The second metal is preferably a metal such as Bi, Te, Sn, Ni, V, Mo, Nd, Nb, or Zr, and is particularly preferably Bi, Te, Ni, or Nb.

According to the invention, a cathode exhibiting excellent transparency and excellent durability can be obtained by using the first metal and the second metal in combination. Therefore, an organic EL device exhibiting excellent durability can be fabricated. It appears that this is because migration or liquation of the first metal is prevented by the second metal.

The standard oxidation-reduction potential used herein refers to the equilibrium potential (versus normal hydrogen electrode) in water at 25°C and atmospheric pressure.

The cathode layer preferably contains the first metal as the main component. The "main component" used herein means that the amount of the first metal is greater than the amount of each component other than the first metal contained in the cathode layer. The content of the first metal in the cathode layer is preferably 60 wt% to 99.9 wt%, and still more preferably 80 wt% to 99 wt%.

The cathode layer preferably contains 0.1 wt% to 5.0 wt% of an alkali metal or an alkaline earth metal in addition to the first metal and the second metal. This allows the work function of the cathode layer to be decreased, whereby electrons can be smoothly injected into the hole transporting layer. The content of the alkali metal or the alkaline earth metal in the cathode layer is preferably 1 wt% to 10 wt%, and still more preferably 2 wt% to 5 wt%. As the alkali metal or the alkaline earth metal, Li, Mg, Ca, or Cs is particularly preferable.

The cathode layer preferably has an optical transparency at a wavelength of 380 nm to 780 nm of 10% or more. If the optical transparency is less than 10%, since light generated in the emitting layer cannot be sufficiently outcoupled from the device, the luminous efficiency of the device may be decreased. The optical transparency is preferably 20% or more, and particularly preferably 30% or more. The optical transparency used herein refers to the average optical transparency at wavelengths of 380 to 780 nm.

The cathode layer may be formed by a known method such as simultaneously depositing each metal at a specific ratio or simultaneously sputtering each metal.

The thickness of the cathode layer is preferably 0.1 to 10 nm, and still more preferably 0.1 to 5 nm.

In the organic EL device according to the invention, as other constituent elements such as the anode layer and the organic emitting layer, known elements used in an organic EL device may be used without specific limitations. A specific example of the organic EL device according to the invention is described below. Note that the organic EL device according to the invention is not limited to the following embodiment.

Fourth Embodiment

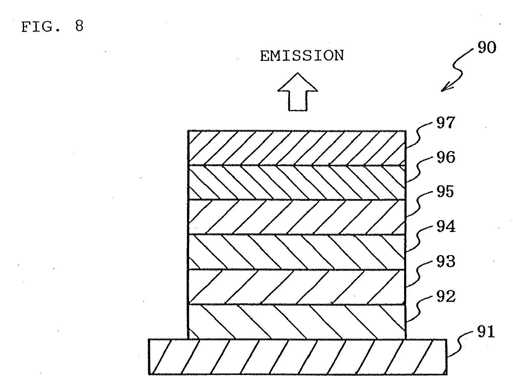

FIG. 8 is a view showing an organic EL device according to one embodiment of the invention.

An organic EL device 90 has a configuration in which an anode layer 92, a hole transporting layer 93, an organic emitting layer 94, an electron transporting layer 95, a cathode 96, and a transparent conductive layer 97 are stacked on a substrate 91 in this order.

The substrate 91 supports the organic EL device. The anode layer 92 supplies holes to the device, and the cathode layer 96 and the transparent conductive layer 97 supply electrons. The hole transporting layer 93 is a layer which receives holes from the anode 92 and assists hole transport to the organic emitting layer 94. Likewise, the electron transporting layer 95 is a layer which receives electrons from the cathode 96 and assists electron transport to the organic emitting layer 94. The organic emitting layer 94 is a layer which emits light upon recombination of electrons and holes.

The organic EL device 90 emits light by applying a voltage between the anode 92 and the cathode 96 to supply electrons and holes to the organic emitting layer 94. The light is outcoupled through the cathode 96.

The organic EL device 90 includes the cathode layer 96 containing the above-described metals in combination.

In a known EL device, a metal (e.g. Ag) used for the cathode layer 96 changes in properties during driving the device and diffuses into the electron transporting layer 95, the organic emitting layer 94, and the like. This causes the deterioration of the organic layers or a short circuit with the anode layer 2 occurs.

In the organic EL device according to the invention, since diffusion of the metals used for the cathode layer can be suppressed, deterioration of the device due to metal diffusion can be effectively prevented. Therefore, the lifetime of the device can be extended.

In the organic EL device 90, glass, a polymer film such as polyester, amorphous silicon, or the like may be used as the material for the substrate 91.

As the material for the anode layer 92, a transparent electrode such as indium tin oxide (ITO) or indium zinc oxide (IZO) or a metal such as Cr or Au may be used. The thickness of the anode layer 92 is preferably 100 nm to 200 nm.

As the material for the hole transporting layer 93, a known material such as a poly-N-vinylcarbazole derivative, polyphenylenevinylene derivative, polyphenylene, polythiophene, polymethylphenylsilane, polyaniline, triazole derivative, oxadiazole derivative, imidazole derivative, polyarylalkane derivative, pyrazoline derivative, pyrazolone derivative, phenylenediamine derivative, arylamine derivative, amino-substituted chalcone derivative, oxazole derivative, carbazole derivative, styrylanthracene derivative, fluorenone derivative, hydrazone derivative, stilbene derivative, porphyrin derivative (e.g. phthalocyanine), aromatic tertiary amine compound, styrylamine derivative, butadiene compound, benzidine derivative, polystyrene derivative, triphenylmethane derivative, tetraphenylbenzene derivative, or starburst polyamine derivative may be used.

The organic emitting layer 94 preferably includes a host compound and a dopant. The host compound transports at least either electrons or holes. As preferable examples of the host compound, a known carbazole derivative, a compound having a condensed heterocyclic skeleton containing a nitrogen atom, and the like can be given. The host compound may be a polymer compound. As examples of the polymer compound used as the host, a monomer or an oligomer (e.g. dimer or trimer) containing carbazole, a polymer compound containing a carbazole group, and the like can be given.

As the material for the electron transporting layer 95, a known oxadiazole derivative, triazole derivative, triazine derivative, nitro-substituted fluorenone derivative, pyrane dioxide derivative, diphenylquinone derivative, fluoronylidenemethane derivative, anthrone derivative, perylene derivative, oxine derivative, quinoline complex derivative, or the like may be used.

As the material for the transparent conductive layer 97, a known transparent conductive material such as tin oxide, ITO, or IZO may be used. An organic material such as polyaniline, polythiophene, polypyrrole, or a derivative thereof may also be used as the material for the transparent conductive layer 97. In particular, a film formed with IZO at a low temperature of 150°C or less is preferable.

EXAMPLES

First Invention

Example 1

An organic EL device having a configuration shown in FIG. 1 was fabricated.
As the material for the anode 20, an alloy of chromium and cerium (work function: 5.3 eV) was used. The alloy was deposited on the glass substrate 10 by DC sputtering to a thickness of 200 nm. Argon (Ar) was used as the sputtering gas. The pressure was 0.2 Pa, and the DC output was 300 W. The deposited alloy was patterned into a specific shape using lithographic technology. As the etchant, "ETCH-1" (manufactured by Sanyo Chemical Industries, Ltd.) was used. This etchant allows chromium to be processed with high accuracy and high reproducibility. Dry etching may also be used when higher processing accuracy is required. As the etching gas, a mixed gas of chlorine ($C1_2$) and oxygen ($O_2$) may be used. In particular, use of reactive ion etching (RIE) allows highly accurate processing and enables the shape of the etched surface to be controlled. The material can be formed in a tapered shape by etching under specific conditions, whereby a short circuit between the cathode 50 and the anode 20 can be reduced.
Then, silicon dioxide ($SiO_2$) was formed on the substrate 10 as the insulating layer 30 by sputtering to a thickness of 200 nm. The $SiO_2$ was processed using lithographic technology so that an opening was formed on the anode 20. The $SiO_2$ was etched using a mixture of hydrofluoric acid and ammonium fluoride. The resulting opening is the emitting section of the organic EL device.
After placing the glass substrate 10 in a vacuum deposition device, the emitting layer 40 and the metal layer 52 of the cathode 50 were formed by deposition. When forming the emitting layer 40, 4,4',4"-tris(3-methylphenylphenylamino)triphenylamine (MTDATA) was used for the hole injecting layer 42, bis(N-naphthyl)-N-phenylbenzidine (α-NPD) was used for the hole transporting layer 44, and an 8-quinolinolaluminum complex (Alq) was used for the luminescent medium layer 46. An alloy of magnesium and silver (Mg:Ag) was used for the metal layer 52 of the cathode 50. A resistive heating boat was charged with 0.2 g of each material forming the emitting layer 40, and attached to a specific electrode of the vacuum deposition device. A boat was charged with 0.1 g of magnesium and 0.4 g of silver as the materials for the metal layer 52, and attached to a specific electrode of the vacuum deposition device. After reducing the pressure inside the vacuum chamber to $1.0 \times 10^{-4}$ Pa, the boats were sequentially heated by applying a voltage to effect deposition. The emitting layer 40 and the metal layer 52 were deposited only in a specific area using a metal mask. The "specific area" means the area in which the anode 20 was exposed on the substrate 10. Since it is difficult to accurately deposit the material only in the area in which the anode 20 is exposed, a deposition mask was designed so that the entire exposed area of the anode 20 was covered (i.e. the edge of the insulating layer 30 was also covered). The MTDATA was deposited as the hole injecting layer 42 to a thickness of 30 nm, the α-NPD was deposited as the hole transporting layer 44 to a thickness of 20 nm, and the Alq was deposited as the luminescent medium layer 46 to a thickness of 50 nm. Then, magnesium and silver were codeposited to form the metal layer 52 on the luminescent medium layer 46. The magnesium and silver were deposited to a thickness of 10 nm at a deposition rate ratio of 9:1.
After placing the glass substrate 10 in another vacuum chamber, the In-Zn-O transparent conductive layer 54 was deposited using the above-mentioned mask. The transparent conductive layer 54 was deposited by DC sputtering. The layer 54 was deposited to a thickness of 200 nm at a pressure of 0.3 Pa and a DC output of 40 W using a mixed gas of argon and oxygen (Ar:$O_2$ = 1000:5 (volume ratio)) as the sputtering gas.
The reflectance of the anode 20 formed on the glass substrate 10 was measured. As a result, the reflectance of the anode 20 was 65% at a wavelength of 460 nm. The transparency of the multilayer cathode 50 measured at a wavelength of 460 nm was 52%.
When applying a current of 25 mA/cm² between the anode and the cathode of the organic EL device of Example 1, the drive voltage was 7 V, and a luminance of 930 cd/m² was observed on the side of the cathode 50. A large amount of light emitted toward the anode 20 was reflected and outcoupled from the side of the cathode 50. Therefore, it was confirmed that the organic EL device exhibited excellent carrier injection properties and excellent emission properties. Occurrence of a dark spot was not observed on the emitting surface. The evaluation results of the EL device thus obtained are shown in Table 1.
The work function was measured using "AC-1" manufactured by Riken Keiki Co., Ltd.

Example 2

An EL device was fabricated in the same manner as in Example 1 except that the anode 20 was formed by depositing an alloy of chromium and lanthanum (Cr:La=90:10) on the glass substrate 10 to a thickness of 200 nm. The evaluation results of the EL device thus obtained are shown in Table 1.

Example 3

An EL device was fabricated in the same manner as in Example 1 except that the anode 20 was formed by depositing an alloy of silver and neodymium (Ag:Nd=90:10) on the glass substrate 10 to a thickness of 200 nm. The evaluation results of the EL device thus obtained are shown in Table 1.

Example 4

An EL device was fabricated in the same manner as in Example 1 except that the anode 20 was formed by depositing an alloy of molybdenum and samarium (Mo:Sm=95:5) on the glass substrate 10 to a thickness of 200 nm. The evaluation results of the EL device thus obtained are shown in Table 1.

Example 5

An EL device was fabricated in the same manner as in Example 1 except that the anode 20 was formed by depositing an alloy of tungsten and europium (W:Eu=95:5) on the glass substrate 10 to a thickness of 200 nm. The evaluation results of the EL device thus obtained are shown in Table 1.

Example 6

An EL device was fabricated in the same manner as in Example 1 except that the anode 20 was formed by depositing an alloy of silver, palladium, copper, and cerium (Ag:Pd:Cu:Ce=95:0.5:1:3.5) on the glass substrate 10 to a thickness of 200 nm. The evaluation results of the EL device thus obtained are shown in Table 1.

Example 7

An EL device was fabricated in the same manner as in Example 1 except that the anode 20 was formed by depositing an alloy of tantalum and neodymium (Ta:Nd=50:50) on the glass substrate 10 to a thickness of 200 nm. The evaluation results of the EL device thus obtained are shown in Table 1.

Example 8

An EL device was fabricated in the same manner as in Example 1 except that the anode 20 was formed by depositing an alloy of niobium and cerium (Nb: Ce=50: 50) on the glass substrate 10 to a thickness of 200 nm. The evaluation results of the EL device thus obtained are shown in Table 1.

Example 9

An EL device was fabricated in the same manner as in Example 1 except that the anode 20 was formed by depositing an alloy of nickel, cobalt, and cerium (Ni:Co:Ce=60:20:20) on the glass substrate 10 to a thickness of 200 nm. The evaluation results of the EL device thus obtained are shown in Table 1.

Example 10

An EL device was fabricated in the same manner as in Example 1 except that the anode 20 was formed by depositing an alloy of platinum and samarium (Pt:Sm=95:5) on the glass substrate 10 to a thickness of 200 nm. The evaluation results of the EL device thus obtained are shown in Table 1.

Example 11

An EL device was fabricated in the same manner as in Example 1 except that the anode 20 was formed by depositing an alloy of silicon and neodymium (Si:Nd=90:10) on the glass substrate 10 to a thickness of 200 nm. The evaluation results of the EL device thus obtained are shown in Table 1.

Example 12

An EL device was fabricated in the same manner as in Example 1 except for forming the anode 20 by depositing silver on the glass substrate 10 by sputtering to a thickness of 190 nm and depositing an alloy of chromium oxide and

cerium oxide ($CrO_2$:$CeO_2$=90:10) to a thickness of 10 nm. The evaluation results of the EL device thus obtained are shown in Table 1.

Comparative Example 1

An EL device was fabricated in the same manner as in Example 1 except that the anode 20 was formed by depositing an ITO transparent conductive film on the glass substrate 10 to a thickness of 200 nm. When applying a current of 25 mA/cm$^2$ between the anode and the cathode of the organic EL device thus obtained, the drive voltage was 8.5 V, and the luminance observed on the side of the cathode 50 was 250 cd/m$^2$, which was lower than that of the organic EL device of Example 1. This suggests that the light propagated toward the anode 20 was reflected to only a small extent and emitted through the glass substrate 10.

Comparative Example 2

An EL device was fabricated in the same manner as in Example 1 except that the anode 20 was formed by depositing an alloy of silver and aluminum (Ag:Al=50:50) on the glass substrate 10 to a thickness of 200 nm. The evaluation results of the EL device thus obtained are shown in Table 1.
TABLE 1

|  | Anode Composition ratio | Work function (eV) | Reflectance of anode (%) | Drive voltage (V) | Luminance (cd/m$^2$) |
|---|---|---|---|---|---|
| Example 1 | Cr:Ce=95:5 | 5.3 | 65 | 7.0 | 930 |
| Example 2 | Cr:La=90:10 | 5.2 | 60 | 6.8 | 930 |
| Example 3 | Ag:Nd=90:10 | 5.0 | 70 | 7.2 | 950 |
| Example 4 | Mo:Sm=95:5 | 5.0 | 65 | 7.2 | 880 |
| Example 5 | W:Eu=95:5 | 5.0 | 60 | 7.2 | 650 |
| Example 6 | Ag:Pd:Cu: Ce=95:0.5:1: 3.5 | 5.3 | 70 | 6.5 | 850 |
| Example 7 | Ta:Nd=50:50 | 5.2 | 60 | 6.5 | 810 |
| Example 8 | Nb:Ce=50:50 | 5.3 | 60 | 6.5 | 780 |
| Example 9 | Ni:Co:Ce=80: 10:10 | 5.3 | 60 | 6.6 | 800 |
| Example 10 | Pt:Sm=95:5 | 5.1 | 60 | 6.8 | 850 |
| Example 11 | Si:Nd=90:10 | 5.0 | 60 | 6.5 | 800 |
| Example 12 | $CrO_2$: $CeO_2$=95:5 | 5.5 | 55 | 6.5 | 800 |
| Comparative Example 1 | ITO | 4.9 | 5 | 8.5 | 300 |
| Comparative Example 2 | Ag:Al=50:50 | 4.0 | 70 | 13.0 | 800 |

As is clear from Table 1, the organic EL device of the example exhibited a low drive voltage due to high hole injection properties and exhibited a high luminance due to a reduction in the amount of heat generated by the device. Moreover, since the light generated by the emitting layer 40 can be efficiently emitted from the upper surface, an excellent top emission can be obtained.

Second Invention

In the example according to the invention, the binding energy in the cerium 3d orbit was measured using an X-ray photoelectron spectrometer ("ESCA5400" manufactured by ULVAC-PHI, Incorporated, X-ray source: Mg-K$\alpha$). An electrostatic hemisphere detector was used as the detector of the X-ray photoelectron spectrometer. The pass energy of the detector was set at 35.75 eV, and the reference for the peak was set at 284.6 eV ($C_{1s}$). The binding energy spectra of the cerium 3d orbit on the surface of the transparent conductive film shown in FIGS. 6 and 7 were also measured under the above conditions.

The "binding energy spectra of the cerium 3d orbit on the surface of the transparent conductive film" measured in the following examples correspond to an example of the "graph showing binding energy of an electron present in a cerium 3d orbit on the surface of the transparent conductive film measured by X-ray photoelectron spectroscopy" defined in the claims.

In the following examples, SA means the total peak area of the binding energy between 877 eV and 922 eV in the binding energy spectrum of the cerium 3d orbit, and SB means the total peak area of the binding energy between 914 eV and 920 eV in this binding energy spectrum.

The work function of the transparent conductive film was measured in air using a photoelectron spectroscope ("AC-1" manufactured by Riken Keiki Co., Ltd.) after cleaning the transparent conductive film using ultraviolet rays (UV).

Example 13

(1) Preparation for production of transparent conductive substrate (preparation of target 1)

An indium oxide powder, tin oxide powder, and cerium oxide powder (each powder had an average particle diameter of 1 $\mu$m or less) were provided at such a ratio that "In/(In+Sn+Ce)" (molar ratio of indium) was 0.9, "Sn/(In+Sn+Ce)" (molar ratio of tin) was 0.05, and "Ce/(In+Sn+Ce)" (molar ratio of cerium) was 0.05, and placed in a wet ball mill container. The powders placed in the wet ball mill container were mixed and ground for 72 hours to obtain a ground product.

Note that, when an element symbol such as Sn, In, or Ce is used in an expression, the element symbol indicates the number of moles of the element. In the following examples, when an element symbol such as Zn or Ga is used in an expression, the element symbol indicates the number of moles of the element.

The resulting ground product was granulated and press-formed to a diameter of 4 inches and a thickness of 5 mm to obtain a formed product. After placing the formed product in a firing furnace, the formed product was fired at 1400°C for 36 hours to obtain a target 1 for the transparent conductive film 112.

(2) Production of transparent conductive substrate

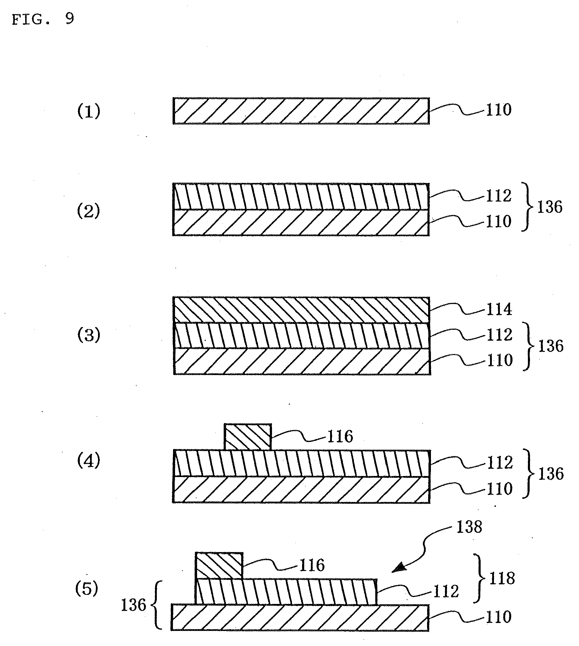

FIG. 9 is an explanatory diagram showing the steps of producing the transparent conductive substrate 138 of Example 13. The transparent glass substrate 110 having a thickness of 1.1 mm, a length of 25 mm, and a width of 75 mm and the target 1 were placed in a vacuum container of an RF sputtering device. The RF sputtering device was operated so that the degree of vacuum in the vacuum container was $5 \times 10^{-4}$ Pa, and argon gas and oxygen (volume ratio was 80:20) were introduced into the vacuum container so that the sputtering pressure was 0.1 Pa. The partial pressure of oxygen was 0.02 Pa. FIG. 9(1) shows the glass substrate 110. The glass substrate 110 corresponds to an example of the transparent substrate defined in the claims. The component ratio of the sputtering gas and the partial pressure of oxygen in the sputtering gas are shown in Table 2.

TABLE 2

|  | Example 13 | Example 14 | Example 15 | Example 16 | Example 17 |
|---|---|---|---|---|---|
| Material for anode layer | $In_2O_3$ $SnO_2$ $CeO_2$ | $In_2O_3$ $CeO_2$ | $In_2O_2$ ZnO $CeO_2$ | $In_2O_3$ $SnO_2$ $CeO_2$ | $In_2O_3$ $ZrO_2$ $CeO_2$ |
| Sputtering gas | Ar:$O_2$=80:20 | Ar 100% | Ar:$O_2$=95:5 | Ar 100% | Ar 100% |
| Partial pressure of oxygen (Pa) | 0.02 | 0 | 0.005 | 0 | 0 |
| Auxiliary wire | Al | Ag | - | Mo | Cr |

(continued)

| | Example 13 | Example 14 | Example 15 | Example 16 | Example 17 |
|---|---|---|---|---|---|
| $Ce_{3d}$ peak area ratio (SB/SA) | 0.12 | 0.02 | 0.025 | 0.029 | 0.029 |
| Work function (eV) | 5.6 | 5.8 | 5.9 | 5.6 | 5.6 |
| Transparency (%) | 89 | 89 | 89 | 89 | 89 |
| Specific resistance of anode layer ($\Omega \cdot$cm) | $5.4 \times 10^{-3}$ | $7.7 \times 10^{-4}$ | $4.9 \times 10^{-4}$ | $5.0 \times 10^{-4}$ | $5.0 \times 10^{-4}$ |
| Material for hole transporting layer | TBDB | TBDB | TBDB | TBDB | TBDB |
| Thickness (nm) | 60 | 60 | 60 | 60 | 60 |
| Material for organic emitting layer | DPVDPAN, D1 | DPVDPAN, D1 | DPVDPAN, D1 | DPVDPAN, D1 | DPVDPAN, D1 |
| Thickness (nm) | 40 | 40 | 40 | 40 | 40 |
| Material for electron injecting layer | Alq | Alq | Alq | Alq | Alq |
| Thickness (nm) | 20 | 20 | 20 | 20 | 20 |
| Material for cathode layer | Al/Li | Al/Li | Al/Li | Al/Li | Al/Li |
| Thickness (nm) | 200 | 200 | 200 | 200 | 200 |
| Current density at 5 V (mA/cm$^2$) | 1.8 | 2.0 | 1.0 | 2.0 | 2.0 |
| Luminance (nit) | 141 | 160 | 160 | 141 | 140 |
| Voltage rise rate after 1000 hrs | 1.7 | 1.4 | 1.6 | 1.7 | 1.4 |
| Evaluation* | Good | Good | Good | Good | Good |

*Evaluated as "Good" when the luminance is 100 nit or more and the voltage rise rate after 1000 hrs is 2.0 or less, otherwise evaluated as "Bad".

Sputtering was performed in the above-described atmosphere using the target 1 at a temperature of the glass substrate 110 in the vacuum container of 200°C, an electric power supply of 100 W, and a deposition time of 14 minutes. As a result, the transparent conductive film 112 having a thickness of 110 nm was formed on the glass substrate 110 to obtain the conductive multilayer body 136. FIG. 9(2) shows the resulting conductive multilayer body 136.
Then, an Al thin film having a thickness of 120 nm (metal film 114) was formed on the transparent conductive film 112 in an argon gas atmosphere using an Al target. FIG. 9(3) shows the resulting metal film 114.

Then, the transparent conductive film 112 and the metal film 114 were etched using an etchant (phosphoric acid-nitric acid-acetic acid aqueous solution (phosphoric acid:nitric acid: acetic acid = 16:1:1)) so that the width of the metal film 114 was 20 $\mu$m to form the Al thin metal wire 116 on the transparent conductive film 112. FIG. 9 (4) shows the resulting thin metal wire 116.

As shown in FIG. 9(5), the transparent conductive film 112 deposited on the glass substrate 110 using the target 1 was etched using an oxalic acid aqueous solution. The transparent conductive film 112 was patterned by etching so that the Al thin metal wire 116 was positioned on one end of the transparent conductive film 112. The thin metal wire 116 and the transparent conductive film 112 formed by patterning are hereinafter collectively called a patterned electrode 118.

The glass substrate 110 and the patterned electrode 118 are hereinafter collectively called the transparent conductive substrate 138. The transparent conductive substrate 138 corresponds to an example of the electrode substrate for an organic electroluminescent device defined in the claims. FIG. 9(5) shows the transparent conductive substrate 138. The width of the transparent conductive film 112 deposited using the target 1 was 90 $\mu$m. The Al thin metal wire 116 formed by etching corresponds to an example of the metal conductor defined in the claims.

The transparent conductive substrate 138 was subjected to ultrasonic cleaning in isopropyl alcohol, dried in a nitrogen gas ($N_2$) atmosphere, and cleaned for 10 minutes using ultraviolet rays (UV) and ozone.

(3) Measurement results for properties of transparent conductive substrate

The specific resistance of the transparent conductive film 112 deposited using the target 1 was measured and found to be $5.4 \times 10^{-3}$ $\Omega \cdot$cm. The transparency of the patterned electrode 118 (transparency at a wavelength of 550 nm) was measured and found to be 89%. The work function of the transparent conductive film 112 of the transparent conductive substrate 138 after UV cleaning was measured using a photoelectron spectroscope ("AC-1" manufactured by Riken Keiki Co., Ltd.) and found to be 5. 6 eV. The measurement results are shown in Table 2.

The $Ce_{3d}$ peak on the surface of the patterned electrode 118 was measured using an XPS. As a result, the ratio "SB/SA" (area ratio of SB to SA) was 0.12. The measurement results are also shown in Table 2.

(4) Fabrication of organic EL device

The transparent conductive substrate 138 was secured on a substrate holder in a vacuum container of a vacuum deposition device, and the pressure inside the vacuum container was reduced so that the degree of vacuum was $1 \times 10^{-6}$ Torr or less. The hole transporting layer 126, organic emitting layer 128, electron injecting layer 130, and cathode layer 132 were stacked on the patterned electrode 118 of the transparent conductive substrate 138 in this order to obtain the organic EL device 134. FIG. 5 shows the resulting organic EL device 134. The vacuum container was maintained under vacuum during the period in which the organic emitting layer 128 to the cathode layer 132 were formed. As described above, the films were deposited under constant vacuum conditions in this embodiment. The organic EL device 134 corresponds to an example of the organic electroluminescent device defined in the claims.

The conditions (material and procedure) for fabricating the organic EL device 134 by vacuum deposition are described below.

The hole transporting layer 126 having a thickness of 60 nm was deposited under vacuum on the transparent conductive film 112 of the transparent conductive substrate 138 using TBDB as the material. Then, the organic emitting layer 128 having a thickness of 40 nm was codepositied under vacuum on the hole transporting layer 126 using DPVDPAN and D1 as the materials. The deposition rate of DPVDPAN was 40 nm/s, and the deposition rate of D1 was 1 nm/s.

The electron injecting layer 130 having a thickness of 20 nm was deposited under vacuum on the organic emitting layer 128 using Alq as the material. The cathode layer 132 was then formed on the electron injecting layer 130 by depositing Al and Li under vacuum to obtain the organic EL device 134. The deposition rate of Al was 1 nm/s, the deposition rate of Li was 0.01 nm/s, and the thickness of Al/Li was 200 nm.

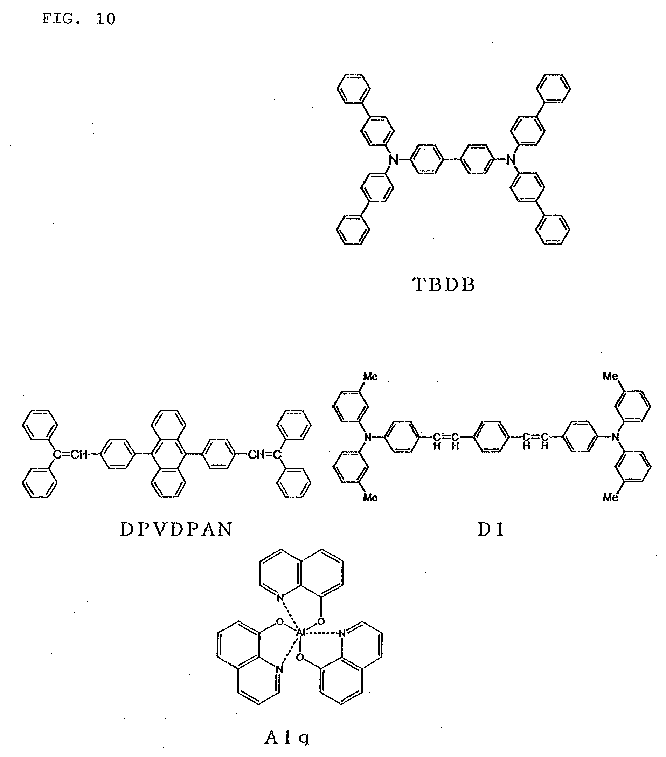

The material and the thickness of each layer are shown in Table 2. FIG. 10 shows the chemical formulas of TBDB, DPVDPAN, D1, and Alq.

(5) Evaluation of organic EL device

A DC voltage of 5. 0 V was applied between the cathode layer 132 (negative electrode) and the transparent conductive film 112 (positive electrode) of the organic EL device 134.

The current density was 1.8 mA/cm$^2$, and the luminance of the organic EL device 134 was 141 nit (cd/m$^2$). It was confirmed that the color of light emitted from the organic EL device 134 was blue.

As a durability evaluation, the organic EL device 134 was driven at a constant current of 10 mA/cm$^2$. When the initial voltage is indicated by $V_0$ and the voltage after 1000 hours elapsed is indicated by V, the voltage rise rate (=V/V$_0$) was as small as 1.7.

Example 14

(1) Preparation for production of transparent conductive substrate (preparation of target 2)

An indium oxide powder and cerium oxide powder (each powder had an average particle diameter of 1 $\mu$m or less) were provided at such a ratio that "In/(In+Ce)" (molar ratio of indium) was 0.95 and "Ce/(In+Ce)" (molar ratio of cerium) was 0.05, and placed in a wet ball mill container. The powders placed in the wet ball mill container were mixed and ground for 72 hours to obtain a ground product.

The formed product was granulated, press-formed, and fired in the same manner as in (1) of Example 13 to obtain a target 2 for the transparent conductive film 112.

(2) Production of transparent conductive substrate

The glass substrate 110 similar to that used in Example 13 and the target 2 were placed in a vacuum container of an RF sputtering device. The RF sputtering device was operated so that the degree of vacuum in the vacuum container was $5 \times 10^{-4}$ Pa, and argon gas was introduced into the vacuum container so that the sputtering pressure was 0.1 Pa. FIG. 9(1) shows the resulting glass substrate 110. Since only argon was used as the component of the sputtering gas introduced into the vacuum container, the partial pressure of oxygen was 0 Pa (Table 2).

Sputtering was performed in the above-described atmosphere using the target 2 at a temperature of the glass substrate 110 in the vacuum container of 200°C, an electric power supply of 100 W, and a deposition time of 14 minutes. As a result, the transparent conductive film 12 having a thickness of 110 nm was formed on the glass substrate 110 to obtain the conductive multilayer body 136. FIG. 9(2) shows the resulting conductive multilayer body 136.

Then, an Ag thin film having a thickness of 120 nm (metal film 114) was formed on the transparent conductive film 112 in an argon gas atmosphere using an Ag target. FIG. 9(3) shows the resulting metal film 114. Then, the transparent conductive film 112 and the metal film 114 were etched using an etchant (phosphoric acid-nitric acid-acetic acid aqueous solution (phosphoric acid:nitric acid: acetic acid = 8:1:8)) so that the width of the metal film 114 was 20 $\mu$m to form the Ag thin metal wire 116 on the transparent conductive film 112. FIG. 9 (4) shows the resulting thin metal wire 116.

As shown in FIG. 9(5), the transparent conductive film 112 deposited on the glass substrate 110 using the target 2 was etched to a width of 90 $\mu$m using an oxalic acid aqueous solution to obtain the same pattern as in Example 13. The thin metal wire 116 and the transparent conductive film 112 formed by patterning are hereinafter collectively called the patterned electrode 118.
The glass substrate 110 and the patterned electrode 118 are hereinafter collectively called the transparent conductive substrate 138. The transparent conductive substrate 138 corresponds to an example of the electrode substrate for an organic electroluminescent device defined in the claims. FIG. 9(5) shows the transparent conductive substrate 138. The Ag thin metal wire 116 formed by etching corresponds to an example of the metal conductor defined in the claims.
The transparent conductive substrate 138 was subjected to ultrasonic cleaning in isopropyl alcohol, dried in a nitrogen gas ($N_2$) atmosphere, and cleaned for 10 minutes using ultraviolet rays (UV) and ozone.

(3) Measurement results for properties of transparent conductive substrate

The specific resistance of the transparent conductive film 112 deposited using the target 2 was measured and found to be $7.7 \times 10^{-4}$ $\Omega \cdot$cm. The transparency of the patterned electrode 118 (transparency at a wavelength of 550 nm) was measured and found to be 89%. The work function of the transparent conductive film 112 of the transparent conductive substrate 138 after UV cleaning was measured using a photoelectron spectroscope ("AC-1" manufactured by Riken Keiki Co., Ltd.) and found to be 5.8 eV. The measurement results are shown in Table 2.
The $Ce_{3d}$ peak on the surface of the patterned electrode 118 was measured using an XPS. As a result, the ratio "SB/SA" (area ratio of SB to SA) was 0.02. The measurement results are also shown in Table 2.

(4) Fabrication of organic EL device

As shown in FIG. 5, the hole transporting layer 126, organic emitting layer 128, electron injecting layer 130, and cathode layer 132 were stacked in this order on the patterned electrode 118 of the transparent conductive substrate 138 in the same manner as in Example 13 to obtain the organic EL device 134. The organic EL device 134 corresponds to an example of the organic electroluminescent device defined in the claims.

(5) Evaluation of organic EL device

A DC voltage of 5. 0 V was applied between the cathode layer 132 (negative electrode) and the transparent conductive film 112 (positive electrode) of the organic EL device 134.
The current density was 2.0 mA/cm$^2$, and the luminance of the organic EL device 134 was 160 nit (cd/m$^2$). It was confirmed that the color of light emitted from the organic EL device 134 was blue.
As a durability evaluation, the organic EL device 134 was driven at a constant current of 10 mA/cm$^2$. When the initial voltage is indicated by $V_0$ and the voltage after 1000 hours elapsed is indicated by V, the voltage rise rate (=$V/V_0$) was as small as 1.4.

Example 15

(1) Preparation for production of transparent conductive substrate (preparation of target 3)

An indium oxide powder, zinc oxide powder, and cerium oxide powder (each powder had an average particle diameter of 1 $\mu$m or less) were provided at such a ratio that "In/ (In+Zn+Ce)" (molar ratio of indium) was 0.9, "Zn/ (In+Zn+Ce)" (molar ratio of zinc) was 0.05, and "Ce/(In+Zn+Ce)" (molar ratio of cerium) was 0.05, and placed in a wet ball mill container. The powders placed in the wet ball mill container were mixed and ground for 72 hours to obtain a ground product.

The formed product was granulated, press-formed, and fired in the same manner as in (1) of Example 13 to obtain a target 3 for the transparent conductive film 112.

(2) Production of conductive multilayer body

The glass substrate 110 similar to that used in Example 13 and the target 3 were placed in a vacuum container of an RF sputtering device. The RF sputtering device was operated so that the degree of vacuum in the vacuum container was $5 \times 10^{-4}$ Pa, and argon gas and oxygen (volume ratio was 95:5) were introduced into the vacuum container so that the sputtering pressure was 0.1 Pa. The partial pressure of oxygen was 0.005 Pa. FIG. 9(1) shows the resulting glass substrate 110. The component ratio of the sputtering gas and the partial pressure of oxygen in the sputtering gas are shown in Table 2.

Sputtering was performed in the above-described atmosphere using the target 3 at a temperature of the glass substrate 110 in the vacuum container of 200°C, an electric power supply of 100 W, and a deposition time of 14 minutes. As a result, the transparent conductive film 112 having a thickness of 110 nm was formed on the glass substrate 110 to obtain the conductive multilayer body 136. FIG. 9(2) shows the resulting conductive multilayer body 136.

Then, the transparent conductive film 112 deposited on the glass substrate 110 using the target 3 was etched to a width of 90 $\mu$m using an oxalic acid aqueous solution. The transparent conductive film 112 patterned to a width of 90 $\mu$m is hereinafter called the patterned electrode 118.

The glass substrate 110 and the patterned electrode 118 are hereinafter collectively called the conductive multilayer body 136. The conductive multilayer body 136 corresponds to an example of the conductive multilayer body defined in the claims.

The conductive multilayer body 136 was subjected to ultrasonic cleaning in isopropyl alcohol, dried in a nitrogen gas ($N_2$) atmosphere, and cleaned for 10 minutes using ultraviolet rays (UV) and ozone.

(3) Measurement results for properties of conductive multilayer body

The specific resistance of the transparent conductive film 112 deposited using the target 3 was measured and found to be $4.9 \times 10^{-4}$ $\Omega \cdot$cm. The transparency of the patterned electrode 118 (transparency at a wavelength of 550 nm) was measured and found to be 89%. The work function of the transparent conductive film 112 of the conductive multilayer body 136 after UV cleaning was measured using a photoelectron spectroscope ("AC-1" manufactured by Riken Keiki Co., Ltd.) and found to be 5. 9 eV. The measurement results are shown in Table 2.

The $Ce_{3d}$ peak on the surface of the patterned electrode 118 was measured using an XPS. As a result, the ratio "SB/SA" (area ratio of SB to SA) was 0.025. The measurement results are also shown in Table 2.

(4) Fabrication of organic EL device

The hole transporting layer 126, organic emitting layer 128, electron injecting layer 130, and cathode layer 132 were stacked on the patterned electrode 118 of the conductive multilayer body 136 in the same manner as in Example 13 to obtain the organic EL device 134. The organic EL device 134 corresponds to an example of the organic electroluminescent device defined in the claims.

(5) Evaluation of organic EL device

A DC voltage of 5. 0 V was applied between the cathode layer 132 (negative electrode) and the transparent conductive film 112 (positive electrode) of the organic EL device 134. The current density was 1.0 mA/cm$^2$, and the luminance of the organic EL device 134 was 160 nit (cd/m$^2$). It was confirmed that the color of light emitted from the organic EL device 134 was blue.

As a durability evaluation, the organic EL device 134 was driven at a constant current of 10 mA/cm$^2$. When the initial voltage is indicated by $V_0$ and the voltage after 1000 hours elapsed is indicated by V, the voltage rise rate ($=V/V_0$) was

as small as 1.6.

Example 16

(1) Preparation for production of transparent conductive substrate (preparation of target 4)

An indium oxide powder, tin oxide powder, and cerium oxide powder (each powder had an average particle diameter of 1 $\mu$m or less) were provided at such a ratio that "In/(In+Sn+Ce)" (molar ratio of indium) was 0.90, "Sn/ (In+Sn+Ce)" (molar ratio of tin) was 0.05, and "Ce/(In+Sn+Ce)" (molar ratio of cerium) was 0.05, and placed in a wet ball mill container. The powders placed in the wet ball mill container were mixed and ground for 72 hours to obtain a ground product.
The formed product was granulated, press-formed, and fired in the same manner as in (1) of Example 13 to obtain a target 4 for the transparent conductive film 112.

(2) Production of transparent conductive substrate

The glass substrate 110 similar to that used in Example 13 and the target 4 were placed in a vacuum container of an RF sputtering device. The RF sputtering device was operated so that the degree of vacuum in the vacuum container was $5\times10^{-4}$ Pa, and argon gas was introduced into the vacuum container so that the sputtering pressure was 0.1 Pa. FIG. 9(1) shows the resulting glass substrate 10. Since only argon was used as the component of the sputtering gas introduced into the vacuum container, the partial pressure of oxygen was 0 Pa (Table 2).
Sputtering was performed in the above-described atmosphere using the target 4 at a temperature of the glass substrate 110 in the vacuum container of 200°C, an electric power supply of 100 W, and a deposition time of 14 minutes. As a result, the transparent conductive film 112 having a thickness of 110 nm was formed on the glass substrate 110 to obtain the conductive multilayer body 136. FIG. 9(2) shows the resulting conductive multilayer body 136.
Then, an Mo thin film having a thickness of 120 nm (metal film 114) was formed on the transparent conductive film 112 in an argon gas atmosphere using an Mo target. FIG. 9(3) shows the resulting metal film 114.
Then, the transparent conductive film 112 and the Mo thin film 114 were etched using an aqueous solution of potassium hexacyanoferrate (III) and sodium hydroxide to form the Mo thin metal wire 116 having a width of 20 $\mu$m on the transparent conductive film 112. FIG. 9(4) shows the resulting thin metal wire 116.
As shown in FIG. 9(5), the transparent conductive film 112 deposited on the glass substrate 110 using the target 4 was etched to a width of 90 $\mu$m using an oxalic acid aqueous solution to obtain the same pattern as in Example 13. The thin metal wire 116 and the transparent conductive film 112 formed by patterning are hereinafter collectively called the patterned electrode 118.
The glass substrate 110 and the patterned electrode 118 are hereinafter collectively called the transparent conductive substrate 138. The transparent conductive substrate 138 corresponds to an example of the electrode substrate for an organic electroluminescent device defined in the claims. FIG. 9(5) shows the transparent conductive substrate 138. The Mo thin metal wire 116 formed by etching corresponds to an example of the metal conductor defined in the claims.
The transparent conductive substrate 138 was subjected to ultrasonic cleaning in isopropyl alcohol, dried in a nitrogen gas ($N_2$) atmosphere, and cleaned for 10 minutes using ultraviolet rays (UV) and ozone.

(3) Measurement results for properties of transparent conductive substrate

The specific resistance of the transparent conductive film 112 deposited using the target 4 was measured and found to be $5.0\times10^{-4}$ $\Omega\cdot$cm. The transparency of the patterned electrode 118 (transparency at a wavelength of 550 nm) was measured and found to be 89%. The work function of the transparent conductive film 112 of the transparent conductive substrate 138 after UV cleaning was measured using a photoelectron spectroscope ("AC-1" manufactured by Riken Keiki Co., Ltd.) and found to be 5.6 eV. The measurement results are shown in Table 2.
The $Ce_{3d}$ peak on the surface of the patterned electrode 118 was measured using an XPS. As a result, the ratio "SB/SA" (area ratio of SB to SA) was 0.029. The measurement results are also shown in Table 2.

(4) Fabrication of organic EL device

As shown in FIG. 5, the hole transporting layer 126, organic emitting layer 128, electron injecting layer 130, and cathode layer 132 were stacked on the patterned electrode 118 of the transparent conductive substrate 138 in this order in the same manner as in Example 13 to obtain the organic EL device 134. The organic EL device 134 corresponds to an example of the organic electroluminescent device defined in the claims.

(5) Evaluation of organic EL device

A DC voltage of 5.0 V was applied between the cathode layer 132 (negative electrode) and the transparent conductive film 112 (positive electrode) of the organic EL device 134.

The current density was 2.0 mA/cm$^2$, and the luminance of the organic EL device 134 was 141 nit (cd/m$^2$). It was confirmed that the color of light emitted from the organic EL device 134 was blue.

As a durability evaluation, the organic EL device 134 was driven at a constant current of 10 mA/cm$^2$. When the initial voltage is indicated by $V_0$ and the voltage after 1000 hours elapsed is indicated by V, the voltage rise rate ($=V/V_0$) was as small as 1.7.

Example 17

(1) Preparation for production of transparent conductive substrate (preparation of target 5)

An indium oxide powder, zirconium oxide powder, and cerium oxide powder (each powder had an average particle diameter of 1 $\mu$m or less) were provided at such a ratio that "In/(In+Zr+Ce)" (molar ratio of indium) was 0.9, "Zr/(In+Zr+Ce)" (molar ratio of zirconium) was 0.05, and "Ce/(In+Zr+Ce)" (molar ratio of cerium) was 0.05, and placed in a wet ball mill container. The powders placed in the wet ball mill container were mixed and ground for 72 hours to obtain a ground product.

The formed product was granulated, press-formed, and fired in the same manner as in (1) of Example 13 to obtain a target 5 for the transparent conductive film 112.

(2) Production of transparent conductive substrate

The glass substrate 110 similar to that used in Example 13 and the target 5 were placed in a vacuum container of an RF sputtering device. The RF sputtering device was operated so that the degree of vacuum in the vacuum container was $5 \times 10^{-4}$ Pa, and argon gas was introduced into the vacuum container so that the sputtering pressure was 0.1 Pa. FIG. 9(1) shows the glass substrate 110. The glass substrate 110 corresponds to an example of the transparent substrate defined in the claim. Since only argon was used as the component of the sputtering gas introduced into the vacuum container, the partial pressure of oxygen was 0 Pa (Table 2).

Sputtering was performed in the above-described atmosphere using the target 5 at a temperature of the glass substrate 110 in the vacuum container of 200°C, an electric power supply of 100 W, and a deposition time of 14 minutes. As a result, the transparent conductive film 112 having a thickness of 110 nm was formed on the glass substrate 110 to obtain the conductive multilayer body 136. FIG. 9(2) shows the resulting conductive multilayer body 136.

Then, a Cr thin film having a thickness of 120 nm (metal film 114) was formed on the transparent conductive film 112 in an argon gas atmosphere using a Cr target. FIG. 9(3) shows the resulting metal film 114.

Then, the transparent conductive film 112 and the Cr thin film 114 were etched using an aqueous solution of ammonium ceric nitrate and perchloric acid so that the width of the metal film 114 was 20 $\mu$m to form the Cr thin metal wire 116 on the transparent conductive film 112. FIG. 9(4) shows the resulting thin metal wire 116.

As shown in FIG. 9(5), the transparent conductive film 112 deposited on the glass substrate 110 using the target 5 was etched to a width of 90 $\mu$m using an oxalic acid aqueous solution to obtain the same pattern as in Example 13. The thin metal wire 116 and the transparent conductive film 112 formed by patterning are hereinafter collectively called the patterned electrode 118.

The glass substrate 110 and the patterned electrode 118 are hereinafter collectively called the transparent conductive substrate 138. The transparent conductive substrate 138 corresponds to an example of the electrode substrate for an organic electroluminescent device defined in the claims. FIG. 9(5) shows the transparent conductive substrate 138. The Cr thin metal wire 116 formed by etching corresponds to an example of the metal conductor defined in the claims.

The transparent conductive substrate 138 was subjected to ultrasonic cleaning in isopropyl alcohol, dried in a nitrogen gas (N$_2$) atmosphere, and cleaned for 10 minutes using ultraviolet rays (UV) and ozone.

(3) Measurement results for properties of transparent conductive substrate

The specific resistance of the transparent conductive film 112 deposited using the target 5 was measured and found to be $5.0 \times 10^{-4}$ $\Omega \cdot$cm. The transparency of the patterned electrode 118 (transparency at a wavelength of 550 nm) was measured and found to be 89%. The work function of the transparent conductive film 112 of the transparent conductive substrate 138 after UV cleaning was measured using a photoelectron spectroscope ("AC-1" manufactured by Riken Keiki Co., Ltd.) and found to be 5.6 eV. The measurement results are shown in Table 2.

The $Ce_{3d}$ peak on the surface of the patterned electrode 118 was measured using an XPS. As a result, the ratio "SB/SA" (area ratio of SB to SA) was 0.029. The measurement results are also shown in Table 2.

(4) Fabrication of organic EL device

As shown in FIG. 5, the hole transporting layer 126, organic emitting layer 128, electron injecting layer 130, and cathode layer 132 were stacked on the patterned electrode 118 of the transparent conductive substrate 138 in this order in the same manner as in Example 13 to obtain the organic EL device 134. The organic EL device 134 corresponds to an example of the organic electroluminescent device defined in the claims.

(5) Evaluation of organic EL device

A DC voltage of 5.0 V was applied between the cathode layer 132 (negative electrode) and the transparent conductive film 112 (positive electrode) of the organic EL device 134.

The current density was 2.0 $mA/cm^2$, and the luminance of the organic EL device 134 was 140 nit ($cd/m^2$). It was confirmed that the color of light emitted from the organic EL device 134 was blue.

As a durability evaluation, the organic EL device 134 was driven at a constant current of 10 $mA/cm^2$. When the initial voltage is indicated by $V_0$ and the voltage after 1000 hours elapsed is indicated by V, the voltage rise rate (=$V/V_0$) was as small as 1.4.

Example 18

(1) Preparation for production of transparent conductive substrate (preparation of target 6)

An indium oxide powder, gallium oxide powder, and cerium oxide powder (each powder had an average particle diameter of 1 $\mu$m or less) were provided at such a ratio that "In/(In+Ga+Ce)" (molar ratio of indium) was 0.90, "Ga/(In+Ga+Ce)" (molar ratio of gallium) was 0.05, and "Ce/(In+Ga+Ce)" (molar ratio of cerium) was 0.05, and placed in a wet ball mill container. The powders placed in the wet ball mill container were mixed and ground for 72 hours to obtain a ground product.

The formed product was press-formed and fired in the same manner as in (1) of Example 13 to obtain a target 6 for the transparent conductive film 112.

(2) Production of transparent conductive substrate

The glass substrate 110 similar to that used in Example 13 and the target 6 were placed in a vacuum container of an RF sputtering device. The RF sputtering device was operated so that the degree of vacuum in the vacuum container was $5 \times 10^{-4}$ Pa, and argon gas was introduced into the vacuum container so that the sputtering pressure was 0.1 Pa. FIG. 9(1) shows the resulting glass substrate 110. Since only argon was used as the component of the sputtering gas introduced into the vacuum container, the partial pressure of oxygen was 0 Pa (Table 3).

TABLE 3

|  | Example 18 | Example 19 | Comparative Example 3 | Comparative Example 4 | Comparative Example 5 |
|---|---|---|---|---|---|
| Material for anode layer | $In_2O_3$ $GaO_2$ $CeO_2$ | $In_2O_3$ $SnO_2$ $CeO_2$ | $In_2O_2$ $CeO_2$ | $In_2O_3$ $SnO_2$ | $In_2O_3$ ZnO |
| Sputtering gas | Ar 100% | Ar:$O_2$=80:20 | Ar:$O_2$=70:30 | Ar:$O_2$=90:10 | Ar 100% |
| Partial pressure of oxygen (Pa) | 0 | 0.1 | 0.15 | 0.01 | 0 |
| Auxiliary wire | Mo/Al/No | Al | Al | Al | Al |
| $Ce_{3d}$ peak area ratio (SB/SA) | 0.029 | 0.12 | 0.13 | No Ce peak | No Ce peak |
| Work function (eV) | 5.6 | 5.6 | 4.9 | 4.8 | 4.9 |

(continued)

|  | Example 18 | Example 19 | Comparative Example 3 | Comparative Example 4 | Comparative Example 5 |
|---|---|---|---|---|---|
| Transparency (%) | 90 | 89 | 89 | 91 | 89 |
| Specific resistance of anode layer ($\Omega \cdot$cm) | $5 \times 10^{-4}$ | $5 \times 10^{-3}$ | $8.0 \times 10^{-3}$ | $2.0 \times 10^{-4}$ | $4.0 \times 10^{-4}$ |
| Material for hole transporting layer | TBDB | TBDB | TBDB | TBDB | TBDB |
| Thickness (nm) | 60 | 60 | 60 | 60 | 60 |
| Material for organic emitting layer | DPVDPAN, D1 | DPVDPAN, D1 | DPVDPAN, D1 | DPVDPAN, D1 | DPVDPAN, D1 |
| Thickness (nm) | 40 | 40 | 40 | 40 | 40 |
| Material for electron injecting layer | Alq | Alq | Alq | Alq | Alq |
| Thickness (nm) | 20 | 20 | 20 | 20 | 20 |
| Material for cathode layer | Al/Li | Al/Li | Al/Li | Al/Li | Al/Li |
| Thickness (nm) | 200 | 200 | 200 | 200 | 200 |
| Current density at 5 V (mA/cm$^2$) | 2.0 | 1.6 | 1.3 | 1.4 | 1.4 |
| Luminance (nit) | 135 | 108 | 60 | 80 | 90 |
| Voltage rise rate after 1000 hrs | 1.4 | 1.9 | 3.0 | 1.5 | 1.5 |
| Evaluation* | Good | Good | Bad | Bad | Bad |
| *Evaluated as "Good" when the luminance is 100 nit or more and the voltage rise rate after 1000 hrs is 2.0 or less, otherwise evaluated as "Bad". | | | | | |

Sputtering was performed in the above-described atmosphere using the target 6 at a temperature of the glass substrate 110 in the vacuum container of 200°C, an electric power supply of 100 W, and a deposition time of 14 minutes. As a result, the transparent conductive film 112 having a thickness of 110 nm was formed on the glass substrate 110 to obtain the conductive multilayer body 136. FIG. 9(2) shows the resulting conductive multilayer body 136.

Then, the Mo (10 nm)/Al (100 nm)/Mo (10 nm) metal film 114 was formed in an argon gas atmosphere using an Mo target and an Al target.

Then, the Mo thin film was etched using an aqueous solution of potassium hexacyanoferrate (III) and sodium hydroxide, and the Al thin film was etched using a phosphoric acid-nitric acid-acetic acid aqueous solution (phosphoric acid:nitric acid:acetic acid = 16:1:1) so that the width of the metal film 114 was 20 $\mu$m to form the (Mo/Al/Mo) thin metal wire 116 on the transparent conductive film 112.

The transparent conductive film 112 deposited using the target 6 was etched to a width of 90 $\mu$m using an oxalic acid aqueous solution to obtain the same pattern as in Example 13. The thin metal wire 116 and the transparent conductive film 112 formed by patterning are hereinafter collectively called the patterned electrode 118.

The glass substrate 110 and the patterned electrode 118 are hereinafter collectively called the transparent conductive substrate 138. The transparent conductive substrate 138 corresponds to an example of the electrode substrate for an organic electroluminescent device defined in the claims. The (Mo/Al/Mo) thin metal wire 116 formed by etching corresponds to an example of the metal conductor defined in the claims.

The transparent conductive substrate 138 was subjected to ultrasonic cleaning in isopropyl alcohol, dried in a nitrogen gas ($N_2$) atmosphere, and cleaned for 10 minutes using ultraviolet rays (UV) and ozone.

(3) Measurement results for properties of transparent conductive substrate

The specific resistance of the transparent conductive film 112 deposited using the target 6 was measured and found to be $5.0 \times 10^{-4}$ $\Omega \cdot$cm. The transparency of the patterned electrode 118 (transparency at a wavelength of 550 nm) was measured and found to be 90%. The work function of the transparent conductive film 112 of the transparent conductive substrate 138 after UV cleaning was measured using a photoelectron spectroscope ("AC-1" manufactured by Riken Keiki Co., Ltd.) and found to be 5. 6 eV. The measurement results are shown in Table 3.
The $Ce_{3d}$ peak on the surface of the patterned electrode 118 was measured using an XPS. As a result, the ratio "SB/SA" (area ratio of SB to SA) was 0.029. The measurement results are also shown in Table 3.

(4) Fabrication of organic EL device

The hole transporting layer 126, organic emitting layer 128, electron injecting layer 130, and cathode layer 132 were stacked on the patterned electrode 118 of the transparent conductive substrate 138 in this order in the same manner as in Example 13 to obtain the organic EL device 134. The organic EL device 134 corresponds to an example of the organic electroluminescent device defined in the claims.

(5) Evaluation of organic EL device

A DC voltage of 5. 0 V was applied between the cathode layer 132 (negative electrode) and the transparent conductive film 112 (positive electrode) of the organic EL device 134.
The current density was 2.0 mA/cm$^2$, and the luminance of the organic EL device 134 was 135 nit (cd/m$^2$). It was confirmed that the color of light emitted from the organic EL device 134 was blue.
As a durability evaluation, the organic EL device 134 was driven at a constant current of 10 mA/cm$^2$. When the initial voltage is indicated by $V_0$ and the voltage after 1000 hours elapsed is indicated by V, the voltage rise rate (=$V/V_0$) was as small as 1.4.

Example 19

(1) Preparation for production of transparent conductive substrate (preparation of target 7)

An indium oxide powder, tin oxide powder, and cerium oxide powder (each powder had an average particle diameter of 1 $\mu$m or less) were provided at such a ratio that "In/(In+Sn+Ce)" (molar ratio of indium) was 0.90, "Sn/(In+Sn+Ce)" (molar ratio of tin) was 0.05, and "Ce/(In+Sn+Ce)" (molar ratio of cerium) was 0.05, and placed in a wet ball mill container. The powders placed in the wet ball mill container were mixed and ground for 72 hours to obtain a ground product.
The formed product was granulated, press-formed, and fired in the same manner as in (1) of Example 13 to obtain a target 7 for the transparent conductive film 112.

(2) Production of transparent conductive substrate

The glass substrate 110 similar to that used in Example 13 and the target 7 were placed in a vacuum container of an RF sputtering device. The RF sputtering device was operated so that the degree of vacuum in the vacuum container was $5 \times 10^{-4}$ Pa, and argon gas and oxygen (volume ratio was 80:20) were introduced into the vacuum container so that the sputtering pressure was 0.5 Pa. The partial pressure of oxygen was 0.1 Pa. FIG. 9(1) shows the resulting glass substrate 110. The component ratio of the sputtering gas and the partial pressure of oxygen in the sputtering gas are shown in Table 3.
Sputtering was performed in the above-described atmosphere using the target 7 at a temperature of the glass substrate 110 in the vacuum container of 200°C, an electric power supply of 100 W, and a deposition time of 14 minutes. As a result, the transparent conductive film 112 having a thickness of 110 nm was formed on the glass substrate 110 to obtain the conductive multilayer body 136. FIG. 9(2) shows the resulting conductive multilayer body 136.
Then, an Al thin film having a thickness of 120 nm (metal film 114) was formed on the transparent conductive film 112 in an argon gas atmosphere using an Al target. FIG. 9(3) shows the resulting metal film 114.
Then, the transparent conductive film 112 and the metal film 114 were etched using a phosphoric acid-nitric acid-acetic acid aqueous solution (phosphoric acid:nitric acid: acetic acid = 16:1:1) so that the width of the metal film 114 was 20

μm to form the Al thin metal wire 116 on the transparent conductive film 112. FIG. 9(4) shows the resulting thin metal wire 116.

As shown in FIG. 9(5), the transparent conductive film 112 deposited on the glass substrate 110 using the target 7 was etched to a width of 90 μm using an oxalic acid aqueous solution to obtain the same pattern as in Example 13. The thin metal wire 116 and the transparent conductive film 112 formed by patterning are hereinafter collectively called the patterned electrode 118.

The glass substrate 110 and the patterned electrode 118 are hereinafter collectively called the transparent conductive substrate 138. The transparent conductive substrate 138 corresponds to an example of the electrode substrate for an organic electroluminescent device defined in the claims. FIG. 9(5) shows the transparent conductive substrate 138. The Al thin metal wire 116 formed by etching corresponds to an example of the metal conductor defined in the claims.

The transparent conductive substrate 138 was subjected to ultrasonic cleaning in isopropyl alcohol, dried in a nitrogen gas ($N_2$) atmosphere, and cleaned for 10 minutes using ultraviolet rays (UV) and ozone.

(3) Measurement results for properties of transparent conductive substrate

The specific resistance of the transparent conductive film 112 deposited using the target 7 was measured and found to be $5.0 \times 10^{-3}$ $\Omega \cdot$cm. The transparency of the patterned electrode 118 (transparency at a wavelength of 550 nm) was measured and found to be 89%. The work function of the transparent conductive film 112 of the transparent conductive substrate 138 after UV cleaning was measured using a photoelectron spectroscope ("AC-1" manufactured by Riken Keiki Co., Ltd.) and found to be 5.6 eV. The measurement results are shown in Table 3.

The $Ce_{3d}$ peak on the surface of the patterned electrode 118 was measured using an XPS. As a result, the ratio "SB/SA" (area ratio of SB to SA) was 0.12. The measurement results are also shown in Table 3.

(4) Fabrication of organic EL device

As shown in FIG. 5, the hole transporting layer 126, organic emitting layer 128, electron injecting layer 130, and cathode layer 132 were stacked on the patterned electrode 118 of the transparent conductive substrate 138 in this order in the same manner as in Example 13 to obtain the organic EL device 134. The organic EL device 134 corresponds to an example of the organic electroluminescent device defined in the claims.

(5) Evaluation of organic EL device

A DC voltage of 5.0 V was applied between the cathode layer 132 (negative electrode) and the transparent conductive film 112 (positive electrode) of the organic EL device 134.

The current density was 1.6 mA/cm$^2$, and the luminance of the organic EL device 134 was 108 nit (cd/m$^2$). It was confirmed that the color of light emitted from the organic EL device 134 was blue.

As a durability evaluation, the organic EL device 134 was driven at a constant current of 10 mA/cm$^2$. When the initial voltage is indicated by $V_0$ and the voltage after 1000 hours elapsed is indicated by V, the voltage rise rate ($=V/V_0$) was as small as 1.9.

Comparative Example 3

(1) Preparation for production of transparent conductive substrate (preparation of target 8)

An indium oxide powder and cerium oxide powder (each powder had an average particle diameter of 1 μm or less) were provided at such a ratio that "In/(In+Ce)" (molar ratio of indium) was 0.95 and "Ce/(In+Ce)" (molar ratio of cerium) was 0.05, and placed in a wet ball mill container. The powders placed in the wet ball mill container were mixed and ground for 72 hours to obtain a ground product.

The formed product was granulated, press-formed, and fired in the same manner as in (1) of Example 13 to obtain a target 8 for the transparent conductive film 112.

(2) Production of transparent conductive substrate

The glass substrate 110 similar to that used in Example 13 and the target 8 were placed in a vacuum container of an RF sputtering device. The RF sputtering device was operated so that the degree of vacuum in the vacuum container was $5 \times 10^{-4}$ Pa, and argon gas and oxygen (volume ratio was 70:30) were introduced into the vacuum container so that the sputtering pressure was 0.5 Pa. The partial pressure of oxygen was 0.15 Pa. FIG. 9(1) shows the resulting glass substrate 110. The component ratio of the sputtering gas and the partial pressure of oxygen in the sputtering gas are shown in Table 3.

Sputtering was performed in the above-described atmosphere using the target 8 at a temperature of the glass substrate 110 in the vacuum container of 200°C, an electric power supply of 100 W, and a deposition time of 14 minutes. As a result, the transparent conductive film 112 having a thickness of 110 nm was formed on the glass substrate 110 to obtain the conductive multilayer body 136. FIG. 9(2) shows the resulting conductive multilayer body 136.

Then, an Al thin film having a thickness of 120 nm (metal film 114) was formed on the transparent conductive film 112 in an argon gas atmosphere using an Al target. FIG. 9(3) shows the resulting metal film 114.

Then, the transparent conductive film 112 and the metal film 114 were etched using a phosphoric acid-nitric acid-acetic acid aqueous solution (phosphoric acid: nitric acid: acetic acid = 16: 1: 1) so that the width of the metal film 114 was 20 $\mu$m to form the Al thin metal wire 116 on the transparent conductive film 112. FIG. 9(4) shows the resulting thin metal wire 116.

As shown in FIG. 9(5), the transparent conductive film 112 deposited using the target 8 was etched using an oxalic acid aqueous solution to obtain the same pattern as in Example 13. The thin metal wire 116 and the transparent conductive film 112 formed by patterning are hereinafter collectively called the patterned electrode 118.

The glass substrate 110 and the patterned electrode 118 are hereinafter collectively called the transparent conductive substrate 138. FIG. 9(5) shows the transparent conductive substrate 138.

The transparent conductive substrate 138 was subjected to ultrasonic cleaning in isopropyl alcohol, dried in a nitrogen gas ($N_2$) atmosphere, and cleaned for 10 minutes using ultraviolet rays (UV) and ozone.

(3) Measurement results for properties of transparent conductive substrate

The specific resistance of the transparent conductive film 112 deposited using the target 8 was measured and found to be $8.0 \times 10^{-3}$ $\Omega \cdot$cm. The transparency of the patterned electrode 118 (transparency at a wavelength of 550 nm) was measured and found to be 89%. The work function of the transparent conductive film 112 of the transparent conductive substrate 138 after UV cleaning was measured using a photoelectron spectroscope ("AC-1" manufactured by Riken Keiki Co., Ltd.) and found to be 4.9 eV. The measurement results are shown in Table 3.

The $Ce_{3d}$ peak on the surface of the patterned electrode 118 was measured using an XPS. As a result, the ratio "SB/SA" (area ratio of SB to SA) was 0.13. The measurement results are also shown in Table 3.

(4) Fabrication of organic EL device

As shown in FIG. 5, the hole transporting layer 126, organic emitting layer 128, electron injecting layer 130, and cathode layer 132 were stacked on the patterned electrode 118 of the transparent conductive substrate 138 in this order in the same manner as in Example 13 to obtain the organic EL device 134.

(5) Evaluation of organic EL device

A DC voltage of 5. 0 V was applied between the cathode layer 132 (negative electrode) and the transparent conductive film 112 (positive electrode) of the organic EL device 134.

The current density was 1.3 mA/cm$^2$, and the luminance of the organic EL device 134 was 60 nit (cd/m$^2$) . It was confirmed that the color of light emitted from the organic EL device 134 was blue.

As a durability evaluation, the organic EL device 134 was driven at a constant current of 10 mA/cm$^2$. When the initial voltage is indicated by $V_0$ and the voltage after 1000 hours elapsed is indicated by V, the voltage rise rate (=$V/V_0$) was as large as 3.0.

Comparative Example 4

(1) Preparation for production of transparent conductive substrate (preparation of target 9)

An indium oxide powder and tin oxide powder (each powder had an average particle diameter of 1 $\mu$m or less) were provided at such a ratio that "In/(In+Sn)" (molar ratio of indium) was 0.95 and "Sn/ (In+Sn)" (molar ratio of tin) was 0.05, and placed in a wet ball mill container. The powders placed in the wet ball mill container were mixed and ground for 72 hours to obtain a ground product.

The formed product was granulated, press-formed, and fired in the same manner as in (1) of Example 13 to obtain a target 9 for the transparent conductive film 112.

(2) Production of transparent conductive substrate

The glass substrate 110 similar to that used in Example 13 and the target 9 were placed in a vacuum container of an RF sputtering device. The RF sputtering device was operated so that the degree of vacuum in the vacuum container was $5 \times 10^{-4}$ Pa, and argon gas and oxygen (volume ratio was 90:10) were introduced into the vacuum container so that the sputtering pressure was 0.1 Pa. The partial pressure of oxygen was 0.01 Pa. FIG. 9(1) shows the resulting glass substrate 110. The component ratio of the sputtering gas and the partial pressure of oxygen in the sputtering gas are shown in Table 3.

Sputtering was performed in the above-described atmosphere using the target 9 at a temperature of the glass substrate 110 in the vacuum container of 200°C, an electric power supply of 100 W, and a deposition time of 14 minutes. As a result, the transparent conductive film 112 having a thickness of 110 nm was formed on the glass substrate 110 to obtain the conductive multilayer body 136. FIG. 9(2) shows the resulting conductive multilayer body 136.

Then, an Al thin film having a thickness of 120 nm (metal film 114) was formed on the transparent conductive film 112 in an argon gas atmosphere using an Al target. FIG. 9(3) shows the resulting metal film 114.

Then, the transparent conductive film 112 and the metal film 114 were etched using a phosphoric acid-nitric acid-acetic acid aqueous solution (phosphoric acid:nitric acid:acetic acid = 16:1:1) so that the width of the metal film 114 was 20 $\mu$m to form the Al thin metal wire 116 on the transparent conductive film 112. FIG. 9(4) shows the resulting thin metal wire 116.

As shown in FIG. 9(5), the transparent conductive film 112 deposited using the target 9 was etched using an oxalic acid aqueous solution to obtain the same pattern as in Example 13. The thin metal wire 116 and the transparent conductive film 112 formed by patterning are hereinafter collectively called the patterned electrode 118.

The glass substrate 110 and the patterned electrode 118 are hereinafter collectively called the transparent conductive substrate 138. FIG. 9(5) shows the transparent conductive substrate 138.

The transparent conductive substrate 138 was subjected to ultrasonic cleaning in isopropyl alcohol, dried in a nitrogen gas ($N_2$) atmosphere, and cleaned for 10 minutes using ultraviolet rays (UV) and ozone.

(3) Measurement results for properties of transparent conductive substrate

The specific resistance of the transparent conductive film 112 deposited using the target 9 was measured and found to be $2.0 \times 10^{-4}$ $\Omega \cdot$cm. The transparency of the patterned electrode 118 (transparency at a wavelength of 550 nm) was measured and found to be 91%. The work function of the transparent conductive film 112 of the transparent conductive substrate 138 after UV cleaning was measured using a photoelectron spectroscope ("AC-1" manufactured by Riken Keiki Co., Ltd.) and found to be 4.8 eV. The measurement results are shown in Table 3. Since the transparent conductive film 112 did not contain Ce, the XPS measurement was omitted.

(4) Fabrication of organic EL device

As shown in FIG. 5, the hole transporting layer 126, organic emitting layer 128, electron injecting layer 130, and cathode layer 132 were stacked on the patterned electrode 118 of the transparent conductive substrate 138 in this order in the same manner as in Example 13 to obtain the organic EL device 134.

(5) Evaluation of organic EL device

A DC voltage of 5. 0 V was applied between the cathode layer 132 (negative electrode) and the transparent conductive film 112 (positive electrode) of the organic EL device 134.

The current density was 1.4 mA/cm$^2$, and the luminance of the organic EL device 134 was 80 nit (cd/m$^2$). It was confirmed that the color of light emitted from the organic EL device 134 was blue.

As a durability evaluation, the organic EL device 134 was driven at a constant current of 10 mA/cm$^2$. When the initial voltage is indicated by $V_0$ and the voltage after 1000 hours elapsed is indicated by V, the voltage rise rate ($=V/V_0$) was 1.5.

Comparative Example 5

(1) Preparation for production of transparent conductive substrate (preparation of target 10)

An indium oxide powder and zinc oxide powder (each powder had an average particle diameter of 1 $\mu$m or less) were provided at such a ratio that "In/(In+Zn)" (molar ratio of indium) was 0.93 and "Zn/ (In+Zn) "(molar ratio of zinc) was 0.07, and placed in a wet ball mill container. The powders placed in the wet ball mill container were mixed and ground for 72 hours to obtain a ground product.

The formed product was granulated, press-formed, and fired in the same manner as in (1) of Example 13 to obtain a target 10 for the transparent conductive film 112.

(2) Production of transparent conductive substrate

The glass substrate 110 similar to that used in Example 13 and the target 110 were placed in a vacuum container of an RF sputtering device. The RF sputtering device was operated so that the degree of vacuum in the vacuum container was $5 \times 10^{-4}$ Pa, and argon gas was introduced into the vacuum container so that the sputtering pressure was 0.1 Pa. FIG. 9(1) shows the resulting glass substrate 110. Since only argon was used as the component of the sputtering gas introduced into the vacuum container, the partial pressure of oxygen was 0 Pa (Table 3).

Sputtering was performed in the above-described atmosphere using the target 10 at a temperature of the glass substrate 110 in the vacuum container of 200°C, an electric power supply of 100 W, and a deposition time of 14 minutes. As a result, the transparent conductive film 112 having a thickness of 110 nm was formed on the glass substrate 110 to obtain the conductive multilayer body 136. FIG. 9(2) shows the resulting conductive multilayer body 136.

Then, an Al thin film having a thickness of 120 nm (metal film 114) was formed in an argon gas atmosphere using an Al target. FIG. 9(3) shows the resulting metal film 114.

Then, the transparent conductive film 112 and the metal film 114 were etched using a phosphoric acid-nitric acid-acetic acid aqueous solution (phosphoric acid:nitric acid:acetic acid = 16:1:1) so that the width of the metal film 114 was 20 $\mu$m to form the Al thin metal wire 116 on the transparent conductive film 112. FIG. 9(4) shows the resulting thin metal wire 116.

As shown in FIG. 9(5), the transparent conductive film 112 deposited using the target 10 was etched using an oxalic acid aqueous solution to obtain the same pattern as in Example 13. The thin metal wire 116 and the transparent conductive film 112 formed by patterning are hereinafter collectively called the patterned electrode 118.

The glass substrate 110 and the patterned electrode 118 are hereinafter collectively called the transparent conductive substrate 138. FIG. 9(5) shows the transparent conductive substrate 138.

The transparent conductive substrate 138 was subjected to ultrasonic cleaning in isopropyl alcohol, dried in a nitrogen gas ($N_2$) atmosphere, and cleaned for 10 minutes using ultraviolet rays (UV) and ozone.

(3) Measurement results for properties of transparent conductive substrate

The specific resistance of the transparent conductive film 112 deposited using the target 10 was measured and found to be $4.0 \times 10^{-4}$ $\Omega \cdot$cm. The transparency of the patterned electrode 118 (transparency at a wavelength of 550 nm) was measured and found to be 89%. The work function of the transparent conductive film 112 of the transparent conductive substrate 138 after UV cleaning was measured using a photoelectron spectroscope ("AC-1" manufactured by Riken Keiki Co., Ltd.) and found to be 4.9 eV. The measurement results are shown in Table 3. Since the transparent conductive film 112 did not contain Ce, the XPS measurement was omitted.

(4) Fabrication of organic EL device

As shown in FIG. 5, the hole transporting layer 126, organic emitting layer 128, electron injecting layer 130, and cathode layer 132 were stacked on the patterned electrode 118 of the transparent conductive substrate 138 in this order in the same manner as in Example 13 to obtain the organic EL device 34.

(5) Evaluation of organic EL device

A DC voltage of 5.0 V was applied between the cathode layer 132 (negative electrode) and the transparent conductive film 112 (positive electrode) of the organic EL device 134.

The current density was 1.4 mA/cm$^2$, and the luminance of the organic EL device 134 was 90 nit (cd/m$^2$). It was confirmed that the color of light emitted from the organic EL device 134 was blue.

As a durability evaluation, the organic EL device 134 was driven at a constant current of 10 mA/cm$^2$. When the initial voltage is indicated by $V_0$ and the voltage after 1000 hours elapsed is indicated by V, the voltage rise rate ($=V/V_0$) was 1.5.

Third Invention

Example 20

An organic EL device shown in FIG. 8 was fabricated according to the following method.

As the substrate 91, glass having a thickness of 1.1 mm was used. Cr was deposited on the substrate 91 by sputtering as the anode layer 92 to a thickness of 50 nm. The glass on which Cr was deposited was subjected to ultrasonic cleaning for five minutes in isopropyl alcohol, washed with pure water for five minutes, and then subjected to ultrasonic cleaning for five minutes in isopropyl alcohol.

The cleaned substrate was secured on a substrate holder of a commercially available vacuum deposition device (manufactured by ULVAC, Inc. Ltd.). A molybdenum resistive heating boat was charged with 200 mg of N,N'-diphenyl-N,N'-bis-(3-methylphenyl)-(1,1'-biphenyl)-4,4'-diamine (hereinafter called "TPDA"). Another molybdenum resistive heating boat was charged with 200 mg of 4,4'-(2,2-diphenylvinyl)biphenyl (hereinafter called "DPVBi"). The pressure inside the vacuum chamber was reduced to $1 \times 10^{-4}$ Pa.

The resistive heating boat charged with TPDA was heated to 215 to 220°C to deposit TPDA on the glass substrate on which Cr was deposited at a deposition rate of 0.1 to 0.3 nm/sec to obtain the hole transporting layer 93 having a thickness of 60 nm. The substrate temperature was set at room temperature (about 25°C).

Then, the molybdenum resistive heating boat charged with DPVBi was heated to 220°C without removing the substrate to deposit DPVBi on the hole transporting layer 93 at a deposition rate of 0.1 to 0.2 nm/sec to obtain the organic emitting layer 94 having a thickness of 40 nm. The substrate temperature was set at room temperature.

After removing the substrate on which the anode layer 92, the hole transporting layer 93, and the organic emitting layer 94 were deposited in this order as described above from the vacuum chamber, a stainless steel mask was provided on the emitting layer. The substrate was then secured on the substrate holder.

A molybdenum resistive heating boat was charged with 200 mg of an aluminum chelate complex (Alq: tris(8-quinolinol) aluminum), and installed in the vacuum chamber.

An alumina-coated tungsten basket was charged with 8 g of a silver (Ag) ingot. A molybdenum resistive heating boat was charged with 1 g of a bismuth (Bi) ribbon, and another molybdenum boat was charged with 1 g of magnesium (Mg). After reducing the pressure inside the vacuum chamber to $2 \times 10^{-4}$ Pa, the boat charged with Alq was heated to 280°C by supplying electricity to deposit Alq in a thickness of 20 nm at a deposition rate of 0.3 nm/sec to obtain the electron transporting layer 95.

Then, Ag, Bi, and Mg were codeposited at a deposition rate of 9 nm/sec, 0.8 nm/sec, and 0.2 nm/sec, respectively, to obtain an Ag-Bi-Mg deposited film having a thickness of 2 nm (cathode layer 96). The content of Ag, Bi, and Mg in the cathode layer was measured using an inductively coupled plasma spectrometer (ICP). As a result, the content of Ag, Bi, and Mg was respectively 90 wt%, 8 wt%, and 2 wt%.

Then, ITO was deposited by sputtering as the transparent conductive layer 97 to a thickness of 150 nm to obtain an organic EL device shown in FIG. 8.

Examples 21 to 34 and Comparative Examples 6 to 8

An organic EL device was fabricated in the same manner as in Example 20 except for changing the configuration of the cathode layer as shown in Tables 4 to 6.

The organic EL devices fabricated in Examples 21 to 34 and Comparative Examples 6 to 8 were evaluated for the composition of the cathode layer, the standard oxidation-reduction potential of each metal, the optical transparency of the cathode layer, and the performance. The results are shown in Tables 4 to 6. The organic EL devices were evaluated according to the following methods.

(1) Standard oxidation-reduction potential of metal

A metal was deposited on a glass substrate under the conditions used when forming the cathode in each example. The resulting sample was immersed in a 0.1M lithium perchlorate aqueous solution connected with a normal hydrogen electrode (half cell) through a salt bridge, and the potential was measured using a potentiostat (manufactured by Hokuto Denko Co., Ltd.).

(2) Optical transparency of cathode layer

A glass substrate was provided near an EL substrate holder when forming the organic EL device, and an Ag-Bi-Mg deposited single-layer film (2 nm) was formed on the glass substrate by opening a shutter only when depositing the cathode. The optical transparency of the substrate with the deposited film was measured at a wavelength of 380 to 780 nm using a spectrophotometer ("UV-3100" manufactured by Shimadzu Corporation) to evaluate the average optical transparency in this wavelength region.

(3) Luminance

The initial luminance of the device when setting the current flowing between the electrodes at 30 mA/cm$^2$ was measured using "CS-1000" (manufactured by Minolta).

(4) Lifetime test

The luminance of the device after continuously driving the device at room temperature for 2000 hours under the condition described in (3) was evaluated.

(5) Evaluation of device deterioration

The surface of the device after the lifetime test (4) was observed from the side of the cathode using an optical microscope (magnification: 20) to evaluate a change in the appearance before and after the test.

(6) Evaluation

The organic EL device was evaluated as "Good" when the luminance after the lifetime test was five times the initial luminance and a change in the metal electrode was not observed in the deterioration evaluation, otherwise the organic EL device was evaluated as "Bad".

TABLE 4

| | Example 20 | Example 21 | Example 22 | Example 23 | Example 24 | Example 25 | Example 26 | Example 27 |
|---|---|---|---|---|---|---|---|---|
| A: First metal[1] | Ag:0.78 | Cr:-0.42 | Ge:0.0 | Zn:-0.96 | Al:-1.66 | Ti:-0.37 | In:-0.34 | Co:1.92 |
| B: Second metal[1] | Bi:-0.32 | Te:-0.34 | Sn:0.15 | V:-0.26 | Zr:-1.53 | Cr:-0.42 | Nb:-0.75 | Pt:1.20 |
| C: Third component | Mg | Mg | Li | Mg | Mg | Mg | Mg | Mg |
| Composition of A:B:C (weight ratio) | 90:8:2 | 50:48:2 | 60:35:5 | 90:5:5 | 80:10:10 | 75:20:5 | 60:30:10 | 50:30:20 |
| Cathode optical transparency (%) | 70 | 30 | 35 | 20 | 50 | 30 | 40 | 35 |
| Luminance ($cd/m^2$) | 250 | 150 | 160 | 100 | 180 | 100 | 120 | 110 |
| Luminance after 2000 hrs ($cd/m^2$) | 190 | 130 | 100 | 80 | 150 | 80 | 90 | 90 |
| Appearance after lifetime test | No change | No change | No change | No change | No change | No change | No change | No change |
| Evaluation | Good | Good | Good | Good | Good | Good | Good | Good |

[1]: Numerals in the table indicate the standard oxidation-reduction potentials (V vs. NHE) of the first or second metal.

TABLE 5

| | Example 28 | Example 29 | Example 30 | Example 31 | Example 32 | Example 33 | Example 34 |
|---|---|---|---|---|---|---|---|
| A: First metal[1] | Ni:-0.23 | Ge:0.0 | Cu:0.34 | Ru:0.46 | Pd:0.92 | Pt:1.20 | Ag:0.78 |
| B: Second metal[1] | Bi:-0.32 | Te:-0.34 | Sn:0.15 | V:-0.26 | Ge:0.0 | Cu:0.34 | Bi:-0.32 |
| C: Third component | Mg | Mg | Mg | Mg | Mg | Mg | None |
| Composition of A:B:C (weight ratio) | 48:40:12 | 80:10:10 | 60:30:10 | 85:10:5 | 85:10:5 | 90:8:2 | 80:20:0 |

(continued)

| | Example 28 | Example 29 | Example 30 | Example 31 | Example 32 | Example 33 | Example 34 |
|---|---|---|---|---|---|---|---|
| Cathode optical transparency (%) | 35 | 45 | 40 | 30 | 35 | 15 | 70 |
| Luminance (cd/m$^2$) | 105 | 150 | 150 | 120 | 130 | 250 | 150 |
| Luminance after 2000 hrs (cd/m$^2$) | 80 | 120 | 120 | 90 | 100 | 190 | 120 |
| Appearance after lifetime test | No change | No change | No change | No change | No change | No change | No change |
| Evaluation | Good | Good | Good | Good | Good | Good | Good |
| *1: Numerals in the table indicate the standard oxidation-reduction potentials (V vs. NHE) of the first or second metal. | | | | | | | |

TABLE 6

| | Comparative Example 6 | Comparative Example 7 | Comparative Example 8 |
|---|---|---|---|
| A: First metal*1 | Ag:0.78 | Ag:0.78 | V:-0.26 |
| B: Second metal*1 | Zn:-0.96 | None | Zr:-1.53 |
| C: Third component | Mg | Mg | Mg |
| Composition of A:B:C (weight ratio) | 60:30:10 | 90:0:10 | 80:15:5 |
| Cathode optical transparency (%) | 70 | 90 | 30 |
| Luminance (cd/m$^2$) | 150 | 200 | 100 |
| Luminance after 2000 hrs (cd/m$^2$) | 30 | 30 | 10 |
| Appearance after lifetime test | Spots occurred | Spots occurred | Spots occurred |
| Evaluation | Bad | Bad | Bad |
| *1: Numerals in the table indicate the standard oxidation-reduction potentials (V vs. NHE) of the first or second metal. | | | |

As is clear from the results shown in Tables 4 to 6, it was confirmed that the organic EL devices according to the invention exhibit improved lifetime in comparison with the devices of the comparative examples since deterioration of the cathode layer is prevented.

INDUSTRIAL APPLICABILITY

The organic EL device and the display according to the invention can be used as consumer and industrial displays such as displays for portable telephones, PDAs, car navigation systems, monitors, TVs, and the like.

**Claims**

1. An organic electroluminescent device comprising:

a cathode, an anode, and an emitting layer interposed between the cathode and the anode,
at least a part of the anode in contact with the emitting layer containing at least one element selected from lanthanum, cerium, neodymium, samarium, and europium, and at least one element selected from chromium, tungsten, tantalum, niobium, silver, palladium, copper, nickel, cobalt, molybdenum, platinum, and silicon.

2. The organic electroluminescent device according to claim 1, wherein the total concentration of the at least one element selected from lanthanum, cerium, neodymium, samarium, and europium is 0.1 to 50 wt%.

3. The organic electroluminescent device according to claim 1, wherein the part of the anode in contact with the emitting layer contains cerium.

4. The organic electroluminescent device according to claim 1, wherein the part of the anode in contact with the emitting layer has a work function of 5.0 eV or more.

5. A conductive multilayer body comprising:

an insulative transparent substrate and a transparent conductive film formed on the transparent substrate,
the transparent conductive film containing an oxide containing at least cerium (Ce),

wherein, in a graph showing binding energy of an electron present in a cerium 3d orbit on the surface of the transparent conductive film measured by X-ray photoelectron spectroscopy, when SA represents the total peak area of the binding energy between 877 eV and 922 eV, and SB represents the total peak area of the binding energy between 914 eV and 920 eV, SB/SA which represents an area ratio of SB to SA satisfies the following expression (1).

$$SB/SA < 0.13 \qquad (1)$$

6. The conductive multilayer body according to claim 5, wherein the transparent conductive film contains at least one metal element selected from indium (In), tin (Sn), Zinc (Zn), zirconium (Zr), and gallium (Ga), cerium (Ce), and oxygen (O).

7. A method for producing the conductive multilayer body of claim 5 or 6, comprising:

forming the transparent conductive film by sputtering at a partial pressure of oxygen of 0.1 Pa or less in a sputtering atmosphere.

8. An electrode substrate for an organic electroluminescent device comprising:

the conductive multilayer body of claim 5 or 6, and
a metal conductor formed on the conductive multilayer body, the transparent conductive film driving an organic electroluminescent layer.

9. An organic electroluminescent device comprising,:

the electrode substrate of claim 8, and
an organic electroluminescent layer formed on the electrode substrate.

10. An organic electroluminescent device comprising,:

the conductive multilayer body of claim 5 or 6, and
an organic electroluminescent layer formed on the conductive multilayer body.

11. An electroluminescent device comprising an anode layer, an organic emitting layer, and a cathode layer stacked in this order,
the cathode layer containing at least a first metal and a second metal,
the standard oxidation-reduction potential (E(A)) of the first metal at 25°C being -1.7 (V) or more, and
the standard oxidation-reduction potential (E(B)) of the second metal at 25°C satisfying the following expression (2).

$$E(A) - 1.1 \leq E(B) \qquad (2)$$

12. An electroluminescent device comprising an anode layer, an organic emitting layer, a cathode layer, and a transparent conductive layer stacked in this order,
the cathode layer containing at least a first metal and a second metal,
the standard oxidation-reduction potential (E(A)) of the first metal at 25°C being -1.7 (V) or more, and
the standard oxidation-reduction potential (E(B)) of the second metal at 25°C satisfying the following expression (2).

$$E(A) - 1.1 \leq E(B) \qquad (2)$$

13. The organic electroluminescent device according to claim 11 or 12, wherein the main component of the cathode layer is the first metal.

14. The organic electroluminescent device according to claim 11 or 12, wherein the first metal is a metal selected from Al, Cr, Ta, Zn, Fe, Ti, In, Co, Ni, Ge, Cu, Re, Ru, Ag, Pd, Pt, and Au.

15. The organic electroluminescent device according to claim 11 or 12, wherein the second metal is a metal selected from Bi, Te, Sn, V, Mo, Nd, Nb, and Zr.

16. The organic electroluminescent device according to claim 11 or 12, wherein the cathode layer contains 0.1 wt% to 5.0 wt% of an alkali metal or an alkaline earth metal.

17. The organic electroluminescent device according to claim 11 or 12, wherein the cathode layer has an optical transparency at a wavelength of 380 nm to 780 nm of 10% or more.

18. The organic electroluminescent device according to claim 11 or 12, wherein the first metal is Ag.

19. A display comprising the organic electroluminescent device according to any one of claims 1 to 4 and 9 to 12.

FIG. 1

EMISSION    REFLECTED LIGHT

54 } 50
52

46 } 40
44
42

30
20
10

FIG. 2

PXL

Y DATA LINE

Cs

X SCAN LINE

G

S    D    G    S    TFT2

TFT1    G

D

A    OLED

K

Vdd (NEGATIVE POTENTIAL)

FIG. 3

SCAN LINE X1
SCAN LINE X2
PXL
Y DATA LINE
Y DATA LINE
SCAN LINE XN
60
62

FIG. 4

OLED
80    84    50
40
20
78
74
70
76    TFT2    72    82

FIG. 5

FIG. 6

BINDING ENERGY SPECTRUM OF CERIUM 3d ORBIT

SPECTRUM ORIGINATED IN $Ce^{4+}$ (SB)

SMALLER SB IS PREFERABLE

IN THIS GRAPH, SB/SA<0.13

FIG. 7

BINDING ENERGY SPECTRUM OF CERIUM 3d ORBIT

SPECTRUM ORIGINATED IN $Ce^{4+}$ (SB)

SMALLER SB IS PREFERABLE

IN THIS GRAPH, SB/SA≥0.13

••• SB          ••• SA

FIG. 8

EMISSION

90

97
96
95
94
93
92
91

FIG. 9

(1) ///////// —110

(2) ///////// —112 } 136
        ///////// —110

(3) ///////// —114
    ///////// —112 } 136
    ///////// —110

(4) /// —116
    ///////// —112 } 136
    ///////// —110

(5) 138
    /// —116
    136 { ///////// —112 } 118
         ///////// —110

FIG. 10

TBDB

DPVDPAN

D1

Alq